# EUROPÄISCHE PATENTSCHRIFT

(11) **EP 3 806 594 B1**
(45) Veröffentlichungstag und Bekanntmachung des Hinweises auf die Patenterteilung: **17.09.2025**
(21) Anmeldenummer: 20200442.0
(22) Anmeldetag: 07.10.2020
(51) Int. Cl.: H05K 5/02, H05K 7/20

(54) **AUSSENBEREICHSVORRICHTUNG MIT ELEKTRONISCHER KOMPONENTE**
EXTERIOR DEVICE WITH ELECTRONIC COMPONENTS
DISPOSITIF EXTÉRIEUR POURVU DE COMPOSANTS ÉLECTRONIQUES

(30) Priorität: 10.10.2019 DE 102019007057
(43) Veröffentlichungstag der Anmeldung: 14.04.2021
(73) Patentinhaber: CGF Counsel Group Frankfurt AG, 60549 Frankfurt (DE)
(72) Erfinder: RUPP, Harald, 85416 Langenbach (DE); TREIBER, Wilhelm, 96253 Untersiemau-Ziegelsdorf (DE)
(74) Vertreter: Ter Meer Steinmeister & Partner

(56) Entgegenhaltungen:
- US-A1- 2005 242 908
- US-A1- 2008 239 632
- US-A1- 2013 200 813
- US-A1- 2013 335 206
- US-A1- 2019 226 672
- US-B1- 6 912 408
- US-B2- 7 813 131

## Beschreibung

### TECHNISCHES GEBIET DER ERFINDUNG

Die Erfindung betrifft eine Außenbereichsvorrichtung mit einer in einem Hohlraum der Außenbereichsvorrichtung betriebsbereit angeordneten elektronischen Komponente. Die Außenbereichsvorrichtung umfasst bevorzugt eine zu betreibende elektrische Funktionseinheit der Außenbereichsvorrichtung. Die elektronische Komponente ist beispielsweise eine Energieversorgungskomponente oder eine Netzwerkkomponente, beispielsweise ein aktives Kopplungselement in einem Netzwerk, wie Netzwerkweiche oder Netzwerkrouter für diese elektrische Funktionseinheit. Die elektronische Komponente ist mittels ihres Komponentengehäuses betriebsbereit in der Außenbereichsvorrichtung angeordnet und dort mechanisch fixiert.

### TECHNISCHER HINTERGRUND

Ein Mast, als ein Beispiel für eine Außenbereichsvorrichtung, ist ein allgegenwärtiger Bestandteil der städtischen und ländlichen Landschaft. Beispielsweise kann ein Mast mit einer elektrischen Licht-Funktionseinheit, also einem Beleuchtungsmittel, entlang einer Straße oder eines Gehwegs angeordnet sein, um einem Autofahrer und/oder Fußgänger zu helfen, nachts besser zu sehen bzw. sich besser zu orientieren. Zusätzlich oder alternativ kann an einen Mast eine elektronische Informations-Funktionseinheit, wie Verkehrszeichen, Ampel, Verkehrszähler oder Mautprüfer, angeordnet sein, die zur Beobachtung und Steuerung eines Verkehrsflusses auf der Straße oder dem Gehweg eingesetzt wird. Zusätzlich oder alternativ kann an einem Mast ein Beobachtungs- oder Überwachungsgerät, wie eine Kamera oder ein Verkehrszähler, als elektrische Funktionseinheit angeordnet sein, die zur Beobachtung und Überwachung von Plätzen oder Straßen dient.

Ein derartiger Mast ist bevorzugt eine Außenbereichsvorrichtung eines sogenannten "Smart City" - Konzepts. "Smart City" ist dabei ein Sammelbegriff für ein gesamtheitliches Entwicklungskonzept, das darauf abzielt, eine Landschaft, insbesondere Städte, effizient, technologisch fortschrittlich, ökologisch und sozial inklusiv zu gestalten. Diese Konzepte sollen energieeffizient, emissionsarm, sicher und kostengünstig sein, um Zukunftsthemen, wie eine flächendeckende Breitbandvernetzung, eine flächendeckende E-Mobilität, eine Verkehrsbeobachtung bzw. -überwachung und/oder eine erhöhte Sicherheit zu ermöglichen. Dazu werden die Außenbereichsvorrichtungen mit elektrischen Funktionseinheiten ausgestattet oder die bestehenden elektrischen Funktionseinheiten der Außenbereichsvorrichtungen werden im "Smart City" Konzept verwendet.

So wird in der DE 10 2017 215 079 A1 ein Verfahren zum Erfassen von Verkehrsteilnehmern auf einem Verkehrsweg beschrieben.

So wird in der US 2019/0107273 A1 ein Verfahren zum Konfigurieren einer Sensorplattform einer Straßenlaterne vorgeschlagen, um eine Beleuchtung energieeffizienter zu machen, beispielsweise durch Zählen oder Detektieren von Verkehrsteilnehmern.

In der DE 20 2007 011 309 U1 werden Masten eines Straßenbeleuchtungssystems mit öffentlich zugänglichen Steckdosen ausgestattet, um beispielsweise Verkehrs- oder Transportmittel, insbesondere Elektrofahrzeuge, elektrisch aufladen zu können, oder auch, um ein Benutzerendgerät, wie einen Laptop oder ein Smartphone an dem Straßenbeleuchtungssystem aufladen zu können. Der Zugang zur Steckdose ist dabei zunächst versperrt, um Unberechtigten, die Energie nicht kostenlos zur Verfügung zu stellen. Der Zugang zur Steckdose kann von einem Benutzer freigeschaltet werden, indem sich ein Benutzer an einem Terminal oder einem Webportal authentisiert, wodurch ein elektromechanischer Schieber am Mast die Steckdose freigibt.

In der US 2019/0273313 A1 wird ein Mast beschrieben, der neben Beleuchtungsmitteln und Verkehrsschildern auch HF-Antennen als Funktionseinheiten trägt und im Inneren des Mastes eine konfigurierbare Gitterstruktur zum Beherbergen von Funkeinheiten und Spannungsversorgung aufweist. Eine Masttür ist dabei offen, um Zugang zu den beherbergten Einheiten zu erhalten.

In der US 2019/0226672 A1 wird vorgeschlagen, einen Lichtmast mit einem Kommunikationsmodul als elektrische Funktionseinheit auszugestalten. Dieses Kommunikationsmodul ermöglicht eine Verbindung mit einem Netzwerk, um an dem Lichtmast befindliche Antennen in mobile Kommunikationsnetze, wie WLAN, GSM, LTE etc., einzubinden und beinhaltet Netzwerkweichen, Gateways und Router. Zudem kann der Lichtmast mit einem Energiemodul ausgestattet werden, um eine Energieversorgung für Peripheriegeräte, wie Sensoren, beispielsweise über das Energienetz oder aber auch über Datenleitungen mittels Power on Ethernet bereitzustellen. Mittels des Energiemoduls kann die Energie verwaltet werden. Eine abschließbare Tür am Lichtmast soll Fußgänger daran hindern, an diese Module zu gelangen.

In der US 7 813 131 B2 wird eine Spannungsversorgung für eine Straßenleuchte mit LED beschrieben. Ein Gehäuse der Spannungsversorgung hat einen mehrteiligen Gehäusedeckel, der Kühlrippen umfasst. Eine durchgehende Bodenplatte weist Löcher zur Durchführung von Kabeln für die Spannungsversorgung auf. Diese Bodenplatte ist formschlüssig mit einer Magnetplatte im Inneren des Masts verbunden.

In US 6 912 408 B1, US 2005/242908 A1, US 2013/200813 A1 und US 2008/239632 A1 sind Masten beschrieben, die Wartungsöffnungen aufweisen, um elektronische Komponenten im Inneren des Mastes zugänglich zu machen.

Die Smart City Konzepte benötigen gegebenenfalls ein Netzwerk, um Daten zwischen der elektrischen Funktionseinheit und einer entfernten Netzwerkkomponente austauschen zu können. Dieses Netzwerk ist ein kritisches Netzwerk, das Cyber-Angriffen ausgesetzt sein kann.

Die Smart City Konzepte benötigen gegebenenfalls eine Energieversorgung, um die elektrische Funktionseinheit mit Energie zu versorgen.

Problematisch bei den bekannten Lösungen ist es, dass die Außenbereichsvorrichtung nur einen sehr limitierten Platz für eine Energieversorgung oder die Bereitstellung eines Netzwerkzugangs hat. Gängige und übliche Gehäuse bzw. Trägerkonzepte können deshalb nicht umgesetzt werden. Es bedarf einer neuen Gehäuse- bzw. Trägerlösung für das Bereitstellen des Netzwerkzugangs und/oder Energieversorgung.

Diese neue Gehäuse- bzw. Trägerlösung muss einerseits robust, um trotz Umwelteinflüssen im Außenbereich, wie Niederschlag, Temperaturschwankungen, Sturm dennoch eine unbeeinflusste Funktionalität oder Betriebsbereitschaft für Netzwerkzugang und Energieversorgung zu ermöglichen.

Zudem bewirkt eine steigende Anzahl von elektrischen Funktionseinheiten an einer Außenbereichsvorrichtung oder neue elektrische Funktionseinheiten (wie Ladestationen für Elektrofahrzeuge) einen größeren Energiebedarf bzw. Leistungsaufnahme pro Außenbereichsvorrichtung. Dieser größere Energiebedarf bzw. die erhöhte Leistungsaufnahme führt zu einer größeren Wärmeentwicklung bei Komponenten, die den Netzwerkzugang und/oder die Energieversorgung bereitstellen. Aufgrund des limitierten Platzangebot in der Außenbereichsvorrichtung führt die größere Wärmeentwicklung zu einer schnelleren Überhitzung der Komponente, die den Netzwerkzugang bzw. die Energieversorgung bereitstellt. Damit steigt ein Risiko eines Funktionsausfall der elektrischen Funktionseinheit. Zusätzlich müssen komplexe Kühlmaßnahmen, wie Wasserkühlung, Heat-pipes. Lüfter, Ventilatoren zur Wärmeabfuhr eingesetzt werden. Diese komplexen Kühlmaßnahmen sind teuer, aufwendig zu warten und im Außenbereich nicht ausfallsicher genug.

Problematisch bei den bekannten Lösungen ist es zudem, dass der Datenaustausch zwischen einer entfernten Netzwerkkomponente, bspw. einem Server, einer Basisnetzwerkkomponente (Backbone-Komponente), und einer elektrischen Funktionseinheit nicht weiter gegen Cyberangriffe abgesichert ist. Ein Angreifer, der beispielsweise die elektronische Funktionseinheit manipulieren möchte, wird bislang nicht bei einer entfernten Netzwerkkomponente erkannt und kann so erheblichen Schaden in dem Netzwerk und in der Folge im "Smart City" Konzept anrichten. Beispielsweise kann ein Angreifer eine Licht- oder Ampelsteuerung manipulieren, einen Ladevorgang für ein Elektrofahrzeug sabotieren und/oder unerlaubt Daten von den elektrischen Funktionseinheiten für eigene Zwecke abgreifen. Auch die in der Datenkommunikation verwendeten sicherheitsrelevanten Daten, wie private Schlüssel, Zertifikate, IP-Adressen oder Passwörter könnten so in unerlaubter Weise ausgelesen werden.

Alle bisherigen Lösungen zielen darauf ab, die Außenbereichsvorrichtung selbst verbessert auszugestalten und besser abzusichern, insbesondere durch komplexe Kühlmaßnahmen und mechanische bzw. elektronische Abriegelungen. Derartige Adaptionen an bestehenden und bereits installierten Außenbereichsvorrichtung (also an einer bestehenden Infrastruktur) sind teuer und ungewünscht. Zudem sind diese Maßnahmen ineffizient, wenn die Außenbereichsvorrichtung in entlegenen (weniger frequentierten) Außenbereichen aufgestellt.

### ZUSAMMENFASSUNG DER ERFINDUNG

Der Erfindung liegt die Aufgabe zu Grunde, ein oben erwähntes neues Gehäuse- bzw. Trägerlösung für eine elektronischen Komponente für das Bereitstellen des Netzwerkzugangs und/oder Energieversorgung für eine Außenbereichsvorrichtung bereitstellen. Dieses Gehäusekonzept für eine elektronischen Komponente soll insbesondere in einen platzlimitierten Hohlraum einer Außenbereichsvorrichtung umsetzbar sein. Insbesondere soll mit dem neuen Gehäusekonzept für eine elektronischen Komponente für eine Außenbereichsvorrichtung eine effektive Wärmeableitung einfach umgesetzt werden. Zudem sollen Angriffs- oder Manipulationsversuche zuverlässig erkannt und verhindert werden.

Eine weitere Aufgabe ist die Einhaltung des Datenschutzes, sodass öffentlich erfasste Daten einer elektrischen Funktionseinheit, die der Vertraulichkeit unterliegen, vor unberechtigtem Zugriff geschützt werden.

Zudem soll eine bestehende Infrastruktur von Außenbereichsvorrichtungen nahezu unverändert weiterverwendet werden können. Der Austausch von einer bereits installierten Außenbereichsvorrichtung (wie Mast) zur Bereitstellung zusätzlicher Funktionalität soll unbedingt vermieden werden. Auch soll an der bestehenden Außenbereichsvorrichtung (wie Mast) keine bauliche Veränderung, wie Vergrößern einer Öffnung oder Vergrößern eines Hohlraums oder Anbringen von zusätzlicher Sensorik oder Verriegelungselemente an der bestehenden Außenbereichsvorrichtung durchgeführt werden.

Zusätzlich soll ein Verkabelungsaufwand in einer bestehenden Außenbereichsvorrichtung geringgehalten werden.

Die Aufgabe wird durch die in den unabhängigen Patentansprüchen beschriebenen Merkmale gelöst. Vorteilhafte Ausgestaltungen der Erfindung sind in den abhängigen Ansprüchen angegeben.

Erfindungsgemäß wird eine Außenbereichsvorrichtung mit einer in einem Hohlraum der Außenbereichsvorrichtung betriebsbereit angeordneten elektronischen Komponente vorgeschlagen. Die elektronische Komponente ist mit einer elektrischen Funktionseinheit der Außenbereichsvorrichtung elektrisch verbunden. Die elektronische Komponente weist ein Komponentengehäuse auf. Das Komponentengehäuse ist zugleich auch ein Kühlkörper für die elektronische Komponente. Die elektronische Komponente ist durch das Komponentengehäuse in einem Hohlraum der Außenbereichsvorrichtung mechanisch fixiert. Die elektronische Komponente bzw. das Komponentengehäuse ist vollständig beabstandet von den Innenseiten der Außenbereichsvorrichtung fixiert. Die Außenbereichsvorrichtung weist eine Öffnung zum Einbringen der elektronischen Komponente in den Hohlraum auf.

Eine Außenbereichsvorrichtung ist bevorzugt eine Vorrichtung, die in einem Außenbereich, wie einem öffentlichen oder privaten Platz einer Stadt oder einer ländlichen Gegend stationär installiert ist. In dem Außenbereich ist diese Außenbereichsvorrichtungen Umwelteinflüssen, wie Wetter, Vandalismus, Unfallszenarien ausgesetzt.

Beispielsweise ist eine Außenvorrichtung ein Straßenmöbel (auch Stadtmöbel genannt). Ein Straßenmöbel ist ein Oberbegriff für Gegenstände in einem Außenbereich, einem öffentlichen und privaten Raum, auf einem Platz oder in einer Parkanlage. Ein Straßenmöbel bietet eine im öffentlichen Raum benötigte Funktion an oder dient der Information oder Werbung. Beispielsweise zählen Beleuchtungskörper, Lichtzeichenanlagen oder Verkehrszeichen zu Stadtmöbel.

Beispielsweise ist eine Außenvorrichtung ein Hydrant, ein Telefonverteilkasten, ein Stromversorgungskasten, eine Litfaßsäule oder eine Taxi-Säule.

Beispielsweise und bevorzugt ist eine Außenvorrichtung ein pfeilerartiger Hohlkörper, insbesondere ein Mast. Ein Mast ist hierbei ein Bauwerk mit zumindest einem hohlen pfeiler- bzw. pfostenähnlichen Innenbereich. Die Grundfläche eines Mastes ist im Vergleich zu seiner Höhe vergleichsweise gering. Der Mast dient vorrangig zur Befestigung von elektrischen Funktionseinheiten, wie beispielsweise von Beleuchtungsmitteln (Lichtmast für Straßenbeleuchtung, Flutlicht, Wegelicht, Leuchtreklame) und/oder Einheiten zur Überwachung und/oder Leitung eines Verkehrs (Wegweiser, Lichtsignalanlagen, Lichtzeichenanlagen,

Verkehrsbeschilderung, Mautbrücken, Verkehrszähler) und/oder anderer elektrischer Komponenten, wie beispielsweise Antennen.

Die Außenbereichsvorrichtung hat einen Hohlraum. Der Hohlraum kann sich über das gesamte Innenvolumen einer Außenbereichsvorrichtung erstrecken. Sodann ist die Außenbereichsvorrichtung ein Hohlkörper, beispielsweise in Form eines Hohlzylinders oder eines Hohlkonus oder eines Hohlkegelstumpfes. Alternativ ist nur ein Abschnitt der Außenbereichsvorrichtung mit einem Hohlraum versehen, wodurch der übrige Teil des Außenbereichsvorrichtung als massiver und stabiler Teil verbleibt, so wie es etwa bei einem massiven Pfeiler der Fall ist.

Der Hohlraum ist im Querschnitt beispielsweise rund, oval, dreieckig, viereckig oder mehreckig.

Die elektronische Komponente ist beispielsweise eine aktive Netzwerkkomponente eines Netzwerkes, also ein physisches Gerät, dass für den Datenaustausch (Kommunikation und Interaktion) zwischen einer von der Außenbereichsvorrichtung entfernten Netzwerkkomponente und der elektrischen Funktionseinheit erforderlich ist. Die elektronische Komponente kann beispielsweise ein Gateway, ein Router, eine Netzwerkbrücke, ein Modem, ein drahtloser Zugangspunkt, eine Netzwerkweiche (Switch), ein Netzwerkverteiler (Hub) und /oder ein Repeater sein, beziehungsweise beinhalten. Die elektronische Komponente kann zudem eine hybride Netzwerkkomponente, wie eine Mehrschicht-Netzwerkweiche (=Multilayer-Switch), ein Protokollkonverter, ein Brückenrouter, ein Proxy-Server, eine Firewall, ein Netzwerkadressübersetzer, ein Multiplexer, ein Netzwerk-Interface-Controller sein, beziehungsweise beinhalten.

Bevorzugt ist die elektronische Komponente eine Netzwerkweiche. Das Netzwerk ist bevorzugt ein Metropolitan Area Network, kurz MAN. Das Netzwerk kann in einer bestimmten Bus-Topologie, beispielsweise als Stern-Bus oder als Serien-Bus (sogenanntes Daisy-Chaining), aufgebaut sein. Bei einer Daisy Chain (engl. ,Gänseblümchenkette') Topologie wird eine Anzahl von Hardware-Komponenten in Serie miteinander als Netzwerk verbunden. Dabei ist die erste elektronische Komponente in einer ersten Außenbereichsvorrichtung direkt mit der entfernten Netzwerkkomponente verbunden. Die weiteren elektronischen Komponenten sind in den weiteren Masten eingebracht und jeweils mit ihren Vorgängern verbunden (Prinzip einer Reihenschaltung). So entsteht eine Kette, die sogenannte Daisy Chain. Das Signal zu und von einer elektronische Komponente in einer Außenbereichsvorrichtung, hier vorrangig ein Mast, wird nun über seine Vorgänger bis zur entfernten Netzwerkkomponente, beispielsweise einem Backbone oder einem Server, geleitet.

Alternativ oder zusätzlich ist die elektronische Komponente beispielsweise eine Energieversorgungskomponente für eine elektrische Funktionseinheit der Außenbereichsvorrichtung. Dazu umfasst die elektronische Komponente bevorzugt eine Energieversorgungseinheit, wobei die Energieversorgungseinheit einen ersten Energieanschluss zum Zuführen einer komponentenexternen Versorgungsenergie und zumindest einen zweiten Energieanschluss zum Abgreifen einer Versorgungsenergie für die Funktionseinheit der Außenbereichsvorrichtung aufweist.

Die elektronische Komponente ist bevorzugt eine aktive elektrische Komponente, die sich von passiven elektrischen Komponenten durch das Vorhandensein von Elektronik im Inneren des Komponentengehäuses unterscheidet.

Die elektronische Komponente umfasst ein Komponentengehäuse. Das Komponentengehäuse ist Träger der elektronischen Komponente. Das Komponentengehäuse umfasst in seinem Gehäuseinneren die elektronische Komponente mit beispielsweise einem Sensor, einer Kontrolleinheit und/oder einer Energieversorgungseinheit. Das Komponentengehäuse dient dem Schutz der elektronischen Komponente gegen Berührung, Eindringen von Fremdkörpern und Wasser sowie Stoßfestigkeit. Bevorzugt weist das Komponentengehäuse die Schutzart IP67 auf. Das Komponentengehäuse ermöglicht den Betrieb der elektronischen Komponente bei einem Umgebungstemperaturbereich von -20 bis +85°C, einer Umgebungsluftfeuchtigkeit von 5% bis 95%.

Das Komponentengehäuse ist zugleich auch der Kühlköper für die elektronische Komponente. Das Komponentengehäuse hat beispielsweise einen Wärmewiderstand von mehr als 1,0 K/W. Der Kühlkörper vergrößert eine wärmeabgebende Oberfläche einer im Inneren des Gehäuses befindlichen elektronischen Komponente. Damit kann einer möglichen Beschädigung durch Überhitzung der elektronischen Komponente vorgebeugt werden. Zur Vergrößerung der Oberfläche des Komponentengehäuses sind beispielsweise Kühlrippen und Kühlfinnen an einer oder mehrerer Außenseiten des Komponentengehäuses vorgesehen.

Durch die Ausgestaltung des Komponentengehäuses als Kühlkörper wird eine ausreichende Wärmeabfuhr gewährleistet und es kann auf weitere Kühlmaßnahmen, wie Lüfter, Wasserkühlung, Heat-Pipes, etc. zur Wärmeabfuhr der von der elektronischen Komponente erzeugten Wärme verzichtet werden. Der Gesamtaufbau ist dadurch weniger komplex, verkleinert und somit kostengünstiger.

Das Komponentengehäuse ist bevorzugt aus einem Metall. Bevorzugt wird Aluminium als Gehäusematerial aufgrund des sehr guten Verhältnisses von Gewicht zu Wärmeleitfähigkeit verwendet. Ein geringeres Gewicht ist zu bevorzugen, um eine zuverlässige mechanische Fixierung im Hohlraum der Außenbereichsvorrichtung mit minimalem Aufwand zu gewährleisten.

Das Komponentengehäuse weist bevorzugt eine Maximalabmessung auf, die einen einfachen Einbau (zur Installation) und auch einen einfachen Ausbau (zur Deinstallation, Wartung, Reparatur) der elektronischen Komponente in den Hohlraum der Außenbereichsvorrichtung, insbesondere einem hohlen Mast oder einem hohlen Pfeiler, ermöglicht.

Das Komponentengehäuse weist bevorzugt Minimalabmessung auf, die es ermöglichen, dass das Komponentengehäuse als Kühlkörper der elektronischen Komponente verwendet werden kann, wobei auf innenliegende Kühlkörper oder zusätzliche Lüfter/Ventilatoren oder andere aufwendige Wärmeableitungen (Heat-Pipes, Wasserkühlung) verzichtet werden soll.

Die elektronische Komponente ist beispielsweis innerhalb einer stationär installierten Außenbereichsvorrichtung angeordnet. Dabei ist die elektronische Komponente durch das Komponentengehäuse in einem Hohlraum der Außenbereichsvorrichtung mechanisch fixiert. Das Fixieren der elektronischen Komponente in der Außenbereichsvorrichtung ermöglicht das permanente Festhalten der elektronischen Komponente in einer definierten Position und Lage. Auf diese Weise ist eine Stabilität gegeben, die die Funktionsfähigkeit der elektronischen Komponente garantiert.

Die Position und Lage des Komponentengehäuses ist bevorzugt so zu wählen, dass ein maximaler Wärmeabtransport vom Gehäuse weg ermöglicht wird. Dabei sollten bauliche Begebenheiten der Außenbereichsvorrichtungen beachtet werden. Bevorzugt entspricht eine Längsausdehnung des Komponentengehäuses im fixierten Zustand einer Längsausdehnung der Außenbereichsvorrichtung. Zudem sollte ein ausreichender Abstand zu anderen Wärmequellen im Hohlraum der Außenbereichsvorrichtung eingehalten werden.

Die elektronische Komponente von der bzw. den Innenseiten der Außenbereichsvorrichtung vollständig beabstandet fixiert. Mit Innenseiten werden die inneren Oberflächen des Hohlraums, also das Innere der Außenbereichsvorrichtung bezeichnet. Dabei werden vorrangig Innenseitenflächen, die parallel zu einer Längsachse der Außenbereichsvorrichtung ausgerichtet sind gemeint.

Bevorzugt ist das Komponentengehäuse zentral im Hohlraum angeordnet. Damit weist jede Seitenoberfläche des Komponentengehäuses einen ausreichenden Abstand zu den Innenseitenflächen der Außenbereichsvorrichtung auf. Bevorzugt ist das Komponentengehäuse auf einen Mittelpunkt des Hohlraums hin ausgerichtet. Dies stellt sicher, dass das Komponentengehäuse möglichst gleichmäßig von Luft umgeben ist, also eine kältere Luft um alle Seiten der elektronischen Komponente strömen kann. Wird die elektronische Komponente in einen Mast eingebracht, so sorgt dieses Anordnen aufgrund der Schlotwirkung im Inneren des Mastes für einen optimalen Wärmeabtransport, ohne dass zusätzliche Kühlmaßnahmen, wie Lüfter oder Ventilatoren einzusetzen sind.

Die elektronische Komponente ist beispielsweise als zusätzliche Komponente in die Außenbereichsvorrichtung einbau- und ausbaubar. Somit kann die Außenbereichsvorrichtung mit einer derartigen elektronischen Komponente nachgerüstet werden, um eine höhere Funktionalität bereitzustellen.

Der Hohlraum der Außenbereichsvorrichtung ist von außerhalb der Außenbereichsvorrichtung zugänglich. Der Hohlraum hat dazu eine Öffnung zum Einbringen der elektronischen Komponente in den Hohlraum. Die Öffnung dient zudem auch zum Entnehmen der elektronischen Komponente aus dem Hohlraum, etwa um eine Wartungsmaßnahme an der Außenbereichsvorrichtung oder ein Austausch der elektronischen Komponente oder der elektrischen Funktionseinheit vornehmen zu können. Diese Öffnung ist aufgrund baulicher und statischer Anforderungen der Außenbereichsvorrichtung in ihren Abmessungen begrenzt, sodass ein Nachrüsten einer Außenbereichsvorrichtung bedingt, dass die elektronische Komponente durch diese Öffnung in den Hohlraum platziert und fixiert werden können muss. Die Außenabmessungen des Komponentengehäuses sind daher durch die Abmessungen der Öffnung vorgegeben, eine Maximierung der Oberfläche des Komponentengehäuses zur Verbesserung der Wärmeableitung ist somit durch die Abmessungen der Öffnung begrenzt. Bevorzugt ist eine Längenabmessung der Öffnung größer als eine Breitenabmessung des Komponentengehäuses der elektronischen Komponente.

Die Öffnung ist bevorzugt durch eine Tür oder Klappe mechanisch verschließbar. Damit ist die elektronische Komponente sicher in der Außenbereichsvorrichtung untergebracht und gegenüber Umwelteinflüssen, wie Feuchtigkeit, Temperatur, Vandalismus, äußeren Krafteinflüssen, wie Kollision (Unfälle) oder Sturm, zusätzlich geschützt. Zudem wird so die bestehende Infrastruktur der Außenbereichsvorrichtung weiterverwendet und ein Austausch beispielsweise von Masten zur Bereitstellung zusätzlicher Funktionalität kann vermieden werden.

Die Öffnung ist bevorzugt ein Standardmaß bei der Außenbereichsvorrichtung.

Die elektronische Komponente ist betriebsbereit in der Außenbereichsvorrichtung angeordnet. Betriebsbereit in diesem Zusammenhang bedeutet, dass die elektronische Komponente mit Energie versorgt ist und mechanisch fixiert verbaut ist. Bevorzugt wird die Energieversorgung für die elektronische Komponente innerhalb der Außenbereichsvorrichtung zusätzlich zur Energieversorgung einer elektrischen Funktionseinheit der Außenbereichsvorrichtung bereitgestellt. Beispielsweise könnte die Energieversorgung für die elektronische Komponente von der Energieversorgung einer elektrischen Funktionseinheit der Außenbereichsvorrichtung abgezweigt sein.

Die elektronische Komponente ist mit der elektrischen Funktionseinheit elektrisch verbunden. Dieses Verbinden dient entweder der Zuführung von Versorgungsenergie von der elektronischen Komponente an die elektrische Funktionseinheit oder dem Übertragen eines Datensignals zwischen der elektronischen Komponente und der elektrischen Funktionseinheit, also sowohl dem Senden und/oder dem Empfangen des Datensignals in der elektronischen Komponente.

In einer bevorzugten Ausgestaltung weist die Außenbereichsvorrichtung ein Befestigungselement auf, wobei das Befestigungselement bevorzugt parallel zu einer Längsachse der Außenbereichsvorrichtung in der Außenbereichsvorrichtung angeordnet ist, um das Komponentengehäuse im Hohlraum der Außenbereichsvorrichtung parallel zu einer Längsachse mechanisch zu fixieren.

Das Befestigungselement ist bevorzugt an einer Innenlängsseite der Außenbereichsvorrichtung mechanisch fixiert, um das Komponentengehäuse im Hohlraum der Außenbereichsvorrichtung mechanisch zu fixieren.

Das Befestigungselement ist dabei ein struktureller Bestandteil im Hohlraum der Außenbereichsvorrichtung und entweder ein integraler Bestandteil der Außenbereichsvorrichtung oder eine zusätzliche Komponente der Außenbereichsvorrichtung. Das Befestigungselement ist ausreichend stabil, um das Komponentengehäuse im Hohlraum zu tragen und mechanisch zu fixieren. Das Befestigungselement ist dabei insbesondere an mehreren Punkten mit der Außenbereichsvorrichtung mechanisch lösbar und nicht lösbar verbunden. Das Befestigungselement ist beispielsweise eine in dem Hohlraum der Außenbereichsvorrichtung angeordnete Schienenführung, beispielsweise eine Metallschiene, wie Hutschiene oder Lochschiene. Das Befestigungselement ist beispielsweise mit der Außenbereichsvorrichtung verschweißt, verschraubt oder vernietet. An das Befestigungselement ist das

Komponentengehäuse direkt oder indirekt (über Halteelemente oder Haltevorrichtungen) mechanisch fixiert.

In einer bevorzugten Ausgestaltung weist das Komponentengehäuse zumindest einen Haltebereich an einer Außenseite des Komponentengehäuses auf. An den Haltebereich greift eine Haltevorrichtung formschlüssig an. Der Haltebereich ist beispielsweise eine Ausnehmung, eine Vertiefung, ein Loch oder eine Kavität. In einer einfachen Form ist der Haltebereich ein Loch oder ein Schlitz, in den die Haltevorrichtung formschlüssig und/oder kraftschlüssig angreift. Dazu weist die Haltevorrichtung entsprechende Vorhebungen, Stifte oder Bereiche auf, die möglichst passgenau in die Haltebereiche eingreifen, um das Komponentengehäuse zu halten. Bevorzugt sind zwei Haltebereiche an sich gegenüberliegenden Außenseiten, bevorzugt eine Oberseite und eine Unterseite, die beide senkrecht zu einer Längsachse der elektronischen Komponente angeordnet sind.

Die Haltevorrichtung ist mit dem Befestigungselement der Außenbereichsvorrichtung mechanisch oder magnetisch verbunden. Dadurch wird das mechanische Fixieren der elektronischen Komponente erreicht. Durch die Ausgestaltung mit Haltevorrichtung und Haltebereichen wird das Beabstanden von der Innenseite der Außenbereichsvorrichtung sichergestellt und so, eine Luftumströmung des gesamten Komponentengehäuses zum optimalen Abtransport von durch die elektronische Komponente erzeugte Wärme ermöglicht.

In einer bevorzugten Ausgestaltung ist das Halteelement mit dem Befestigungselement der Außenbereichsvorrichtung durch eine Klemmverbindung, durch eine Rastverbindung, durch eine Klammerverbindung und/oder durch eine Schraubverbindung mechanisch lösbar verbunden.

Diese einfachen Verbindungskonzepte ermöglichen ein einfaches Installieren und Deinstallieren der elektronischen Komponente im platzbeschränkten Hohlraum der Außenbereichsvorrichtung.

In einer bevorzugten Ausgestaltung ist das Komponentengehäuse der Kühlkörper für eine Kontrolleinheit und/oder eine Energieversorgungseinheit innerhalb des Komponentengehäuses der elektronischen Komponente ist. Diese Einheiten sind ursächlich für den Großteil der Wärmeerzeugung der elektronischen Komponente und deren Kühlung durch das als Kühlkörper ausgestalte Komponentengehäuse verringert ein Risiko einer Überhitzung bzw. eines Hitzestaues und in der Folge des Ausfalls/Defekts der elektronischen Komponente.

In einer bevorzugten Ausgestaltung weist das Komponentengehäuse zumindest eine Erhebung an einer Innenseite des Komponentengehäuses auf. Die Erhebung ist bevorzugt parallel zu einer Grundebene der Innenseite aus der die Erhebung hervorragt. Die Erhebung ragt in das Innere des

Komponentengehäuses. Dies ermöglicht die Verringerung eines Abstands zwischen wärmegenerierenden Einheiten der elektronischen Komponente und somit eine verbesserte Wärmekopplung zum Abtransport erzeugter Wärme. Bevorzugt steht die Kontrolleinheit und/oder die Energieversorgungseinheit der elektronischen Komponente direkt gegenüber. Weiter bevorzugt kontaktiert die Kontrolleinheit und/oder die Energieversorgungseinheit der elektronischen Komponente direkt. Das direkte Kontaktieren umfasst auch das Platzieren eines Wärmeableitplättchens oder einer Wärmepaste zwischen der Erhebung und der entsprechenden Einheit der elektronischen Komponente. Bevorzugt ist eine Fläche einer von der Grundebene der Innenseite am weitesten entfernten Oberseite der Erhebung gleich groß oder größer als die Oberfläche der wärmerzeugenden Einheit in der elektronischen Komponente. Durch diese Ausgestaltung kann auf weitere Kühlkörper im Inneren des Komponentengehäuses verzichtet werden, wodurch die Abmessungen des Komponentengehäuses verringert werden können, ohne dass dessen Kühlleistung verringert ist. Die Erhebung ist bevorzugt ein integraler Bestandteil des Komponentengehäuses oder eines zumindest eines Außenteils des Komponentengehäuses. Dadurch kann das Komponentengehäuse vereinfacht hergestellt werden und es wird eine sehr gute Wärmekoppelung erzielt.

In einer bevorzugten Ausgestaltung weist die elektronische Komponente elektrische und/oder optische Anschlüsse ausschließlich an einer Oberseite und/oder einer, der Oberseite gegenüberliegenden, Unterseite der elektronischen Komponente auf, wobei die Oberseite und die Unterseite des Komponentengehäuses der elektronischen Komponente auf. Diese Oberseite und/oder diese Unterseite sind im Wesentlichen senkrecht zu einer Längsachse der Außenbereichsvorrichtung ausgerichtet. Mit einer derartigen Anordnung wird der geringe Platz im Hohlraum der Außenbereichsvorrichtung optimal für eine Wärmeableitung ausgenutzt, denn das Komponentengehäuse kann in Querausrichtung in seinen Ausmaßen maximiert werden, was bei der Platzierung von Anschlüssen an eine Seitenfläche des Komponentengehäuses nicht möglich wäre. Zudem kann so der Aufbau des Komponentengehäuses vereinfacht werden, insbesondere wenn ein mehrteiliges Gehäuse vorgesehen wird, können zwei Seitenteil vollflächig mit Kühlrippen versehen werden. Zudem kann eine Kabelführung im Hohlraum der Außenbereichsvorrichtung optimiert werden, ohne eine Luftströmung zur Kühlung zu beeinträchtigen.

In einer bevorzugten Ausgestaltung ist das Komponentengehäuse mehrteilig, wobei ein erstes Seitenteil des Komponentengehäuses lösbar formschlüssig mit einem zweiten Seitenteil des Komponentengehäuse verbunden ist. Die Seitenteile können durch entsprechende Ausformungen, beispielsweise Nut-Feder-Verbindung oder Verjüngungen (Lippen) an den verbindenden Flächen verbessert kombiniert werden, wodurch die Stabilität des

Komponentengehäuses und auch die elektromagnetische Verträglichkeit verbessert wird. Die gewünschte Schutzart, beispielsweise IP67, des Gehäuses kann so vereinfacht hergestellt werden. Die Seitenteile können Kühlrippen an den Außenseiten aufweisen, um die Wärmeabfuhr zu verbessern. Die Seitenteile sind bevorzugt Strangpressteile.

Das Komponentengehäuse weist zumindest eine Leiterplatine in einem Formfaktor, insbesondere einem PC/104 Formfaktor auf.

Weiter bevorzugt umfasst die elektronische Komponente eine Kontrolleinheit. Die Kontrolleinheit weist zumindest einen ersten Datenanschluss eingerichtet zum Übertragen eines Datensignals zwischen der elektronischen Komponente und einer von der Außenbereichsvorrichtung entfernten Netzwerkkomponente; zumindest einen zweiten Datenanschluss eingerichtet zum Übertragen eines Datensignals zwischen der elektronischen Komponente und der Funktionseinheit der Außenbereichsvorrichtung auf, wobei die Kontrolleinheit eingerichtet ist zum Weiterleiten einer Datenkommunikation zwischen der entfernten Netzwerkkomponente und der elektrischen Funktionseinheit der Außenbereichsvorrichtung.

Die elektronische Komponente weist zudem einen Sensor an dem Komponentengehäuse eingerichtet zum Bereitstellen eines Sensorsignals auf, wobei eine Kontrolleinheit der elektronischen Komponente eingerichtet ist zum Auswerten des empfangenen Sensorsignals; zum Erkennen einer Änderung des Sensorsignals; und zum Alarmieren einer von der Außenbereichsvorrichtung entfernten Netzwerkkomponente, wenn die Änderung des Sensorsignals durch die Kontrolleinheit erkannt wird.

Die elektronische Komponente umfasst einen Sensor, auch als Detektor oder (Messgrößen- oder Mess-) Aufnehmer oder (Mess-)Fühler bezeichnet. Der Sensor ist ein technisches Bauteil, das bestimmte physikalische Eigenschaften (z. B. Wärmemenge, Temperatur, Feuchtigkeit, Druck, Schallfeldgrößen, Helligkeit, Beschleunigung) qualitativ oder als Messgröße quantitativ erfassen kann. Diese Größen werden mittels physikalischer Effekte erfasst und in ein von der Kontrolleinheit verarbeitbares elektrisches Sensorsignal umgeformt und bereitgestellt. Dabei kann die Kontrolleinheit der elektronischen Komponente die Umformung zur Bereitstellung vornehmen oder der Sensor nimmt diese Umformung vor und stellt das Sensorsignal bereit.

Der Sensor ist beispielsweise am Komponentengehäuse befestigt. Bevorzugt ist der Sensor dazu im Inneren des Komponentengehäuse angeordnet und mittels eines Durchgangs/ Durchbohrung am Komponentengehäuse und/oder einem transparenten Teilbereich des Komponentengehäuses für die zu erfassende Eigenschaft eingerichtet, um die außen am Komponentengehäuse vorherrschende physikalische Eigenschaft auch im Inneren des Komponentengehäuses detektieren zu können. Der Sensor kann alternativ auch im Inneren des Komponentengehäuses angeordnet sein, wenn das Erfassen der physikalischen Eigenschaft nicht vom Vorhandensein des Komponentengehäuses beeinträchtigt ist, beispielsweise zum Detektieren einer Bewegung der elektronischen Komponente.

Die Kontrolleinheit der elektronischen Komponente hat zumindest einen ersten Datenanschluss zum Übertragen eines Datensignals. Über dieses Datensignal kann auch zusätzlich eine Versorgungsenergie für die elektronische Komponente bzw. die Kontrolleinheit empfangen werden, um die Betriebsbereitschaft innerhalb der Außenbereichsvorrichtung, beispielsweise eines Mastes herzustellen. Das Datensignal wäre dann beispielsweise mit einem Power-on-Ethernet Signal kombiniert.

Der zumindest eine erste Datenanschluss dient zur Übertragung eines Datensignals zwischen der elektronischen Komponente und einer entfernten Netzwerkkomponente, beispielsweise eine Komponente eines Basisnetzwerks (englisch Backbone) und/oder eines Rechenzentrums und/oder eines Servers und/oder einer anderen elektronischen Komponente, die in einem anderen Mast (bzw. Außenbereichsvorrichtung) integriert ist. Die Entfernung zwischen der Außenbereichsvorrichtung und dieser entfernten Netzwerkkomponente kann von wenigen Metern bis zu mehreren 100 Kilometern betragen.

Bevorzugt ist der zumindest erste Datenanschluss mit einem ersten Anschluss der elektronischen Komponente verbunden, wobei weiter bevorzugt die Kontrolleinheit der elektronischen Komponente zumindest zwei erste Datenanschlüsse jeweils eingerichtet zum Übertragen eines Datensignals zwischen der elektronischen Komponente und zumindest der vom Mast entfernten Netzwerkkomponente aufweist und wobei noch weiter bevorzugt jeder erste Datenanschluss jeweils mit einem ersten Anschluss der elektronischen Komponente verbunden ist. Somit kann die elektronischen Komponente mit mehr als einer entfernten Netzwerkkomponente verbunden sein oder eine größere Datenbandbreite für die Peripheriegeräte bereitstellen. Der erste Anschluss ist beispielsweise ein small form-factor plugabble, kurz SFP, Anschluss, um Platz einzusparen. Alternativ kann mit zwei ersten Anschlüssen auch eine Daisy-Chain Topologie eines Netzwerkes eingerichtet werden.

Die Kontrolleinheit der elektronischen Komponente hat zumindest einen zweiten Datenanschluss zum Übertragen eines Datensignals. Über dieses Datensignal kann auch zusätzlich eine Versorgungsenergie für die elektrische Funktionseinheit der Außenbereichsvorrichtung von der elektronischen Komponente bereitgestellt werden, um die Betriebsbereitschaft, insbesondere die Energieversorgung, der elektrischen Funktionseinheit der Außenbereichsvorrichtung herzustellen. Das Datensignal wäre dann beispielsweise mit einem Power-on-Ethernet Signal kombiniert.

Bevorzugt ist der zumindest zweite Datenanschluss mit einem zweiten Anschluss der elektronischen Komponente verbunden, wobei weiter bevorzugt die Kontrolleinheit der elektronischen Komponente zumindest vier zweite Datenanschlüsse jeweils eingerichtet zum Übertragen eines Datensignals zwischen der elektronischen Komponente und einer elektrischen Funktionseinheit der Außenbereichsvorrichtung aufweist und wobei noch weiter bevorzugt jeder zweite Datenanschluss jeweils mit einem zweiten Anschluss der elektronischen Komponente verbunden ist. Die Anzahl zweiter Datenanschlüsse ist hier nicht beschränkt und könnte auch acht, vierundzwanzig oder mehr sein. Damit ermöglicht eine elektronischen Komponente eine große Funktionalität an nur einer Außenbereichsvorrichtung. Der zweite Anschluss ist beispielsweise ein RJ45 konformer Anschluss.

Ein Datensignal über jeden zweiten Datenanschluss kann individuell verschlüsselt werden. Die Datensignale verschiedener zweiter Datenanschlüsse sind somit untereinander nicht einsehbar, es können demnach verschiedene Serviceanbieter über die gleiche Vorrichtung 1 an verschiedene elektrische Funktionseinheiten der Außenbereichsvorrichtung angeschlossen werden, ohne dass die Serviceanbieter den Datenverkehr untereinander abhören können.

Als elektrische Funktionseinheit der Außenbereichsvorrichtung (nachfolgend auch vereinfacht Peripheriegerät genannt) wird erfindungsgemäß jegliche Funktionseinheit am Mast angesehen. Die elektrische Funktionseinheit der Außenbereichsvorrichtung kann dabei ein Sensor oder ein Aktor sein. Es kann sich dabei um eine elektrische Funktionseinheit der Außenbereichsvorrichtung (Mast) selbst handeln, also beispielsweise ein Beleuchtungsmittel, eine Lichtzeichenanlage, eine Lichtsignalanlage, eine Mautkomponente und/oder eine Antenne sein. Zusätzlich oder alternativ kann die elektrische Funktionseinheiten der Außenbereichsvorrichtung auch ein an der Außenbereichsvorrichtung zu installierendes Gerät sein, wie eine Verkehrsüberwachungseinheit, eine zusätzliche Lichtsignalsteuerung, eine Kamera, ein Drahtlosnetzwerk-Zugangspunkt (WLAN-AP), eine Mobilfunkbasisstation, eine Elektrofahrzeug-Ladestation, und der gleichen mehr. Beispielsweise kann die elektrische Funktionseinheit der Außenbereichsvorrichtung eine Smart City Komponente sein, wie eine Komponente eines "Smart Reallabors", mit zusätzlicher intelligenter Sensorik sein, die eine Erfassung unterschiedlichster Informationen der Umgebung insbesondere zu Verkehr, Wetter und Umwelt ermöglichen und einen stationären Lichtmast zu einem multimodalen Objektträger mit adaptiver Beleuchtung, Energieversorgung und Breitbandanbindung für verschiedenartige Sensoren ausstattet.

Das Peripheriegerät umfasst dabei beispielsweise Sensorik zur Messung von Temperatur, Feuchte, Emissionen, Schadstoffe, Straßenbelag, etc. Das Peripheriegerät liefert beispielsweise Informationen zum Verkehrsfluss als Basis für eine (zentrale oder auch lokale) Optimierung des Verkehrsflusses. Das Peripheriegerät stellt beispielsweise Informationen zur Verfügung, insbesondere eine Unterstützung bei der Suche nach einem freien Parkplatz oder auch Ladestationen für Elektrofahrzeuge oder für eine verbesserte Wahl der Verkehrsmittel auch in Verbindung mit einer aktuellen Wetterlage. Das Peripheriegerät erhöht beispielsweise die Sicherheit durch gezielte Überwachung mittels Kameras. Das Peripheriegerät könnte Teil einer "Gamification" sein.

Die Kontrolleinheit der elektronischen Komponente ist zum Weiterleiten einer Datenkommunikation zwischen der entfernten Netzwerkkomponente und der elektrischen Funktionseinheit der Außenbereichsvorrichtung eingerichtet. Diese Weiterleitung kann unidirektional oder bidirektional sein. Bevorzugt wird eine standardisierte Weiterleitung angewendet, beispielsweise nach dem IEEE 802.1x Protokoll, bei dem eine Media-Access-Control, kurz MAC, Adresse einer elektrischen Funktionseinheit der Außenbereichsvorrichtung zur Absicherung der Datenkommunikation verwendet wird.

Erfindungsgemäß ist die Kontrolleinheit der elektronischen Komponente dazu eingerichtet, das Sensorsignal vom Sensor der elektronischen Komponente zu empfangen und auszuwerten. Dabei kann die Kontrolleinheit der elektronischen Komponente eine Umformung eines physikalischen Effekts, der vom Sensor erfasst wurde, selbst vornehmen, um ein elektrisches Sensorsignal zur Auswertung zu erhalten. Alternativ ist der Sensor bereits mit einer Umformungseinheit ausgestattet und stellt ein elektrisches Sensorsignal bereit, das von der Kontrolleinheit der elektronischen Komponente nur abgefragt wird. Die Energieversorgung des Sensors erfolgt entweder über die Kontrolleinheit der elektronischen Komponente, über die Vorrichtung oder über den Sensor selbst. Der Sensor kann auch über ein Energy-Harvesting Verfahren mit Versorgungsenergie betrieben werden.

Die Kontrolleinheit der elektronischen Komponente ist weiter dazu eingerichtet, eine Änderung des Sensorsignals zu erkennen. Dazu erfolgt beispielsweise ein Vergleich eines Wertes des Sensorsignals, wie Amplitude, Frequenz, Phase, und/oder Zeitdauer mit einem vordefinierten Referenzwert.

Die Kontrolleinheit der elektronischen Komponente ist auch dazu eingerichtet, die entfernte Netzwerkkomponente zu alarmieren, wenn eine Änderung des Sensorsignals erkannt wurde.

Diese erfindungsgemäße elektronische Komponente wertet also Sensorsignale eines Sensors am Gehäuse der Vorrichtung aus und alarmiert die entfernte Netzwerkkomponente bei entsprechender Abnormalität des Sensorsignals. Die entfernte Netzwerkkomponente kann dann als Gegenmaßnahme, die weitergeleitete Datenverbindung umgehend unterbrechen oder in eine Quarantänezone verlagern, um einem möglichen Angriff auf die Datenverbindung schnell entgegenzutreten und so, das Ausspähen von Daten oder Informationen der entfernten Netzwerkkomponente oder der elektronischen Komponente zu verhindern. Mit dieser elektronischen Komponente wird insbesondere ein Netzknoten, der weit entfernt von einem Rechenzentrum oder einem Backbone steht, aber vollen Zugriff auf die bereitgestellte Datenverbindung hat, weiter abgesichert, indem eine Sensorik vorgesehen ist, die einen möglichen Angriff sofort alarmiert.

In einer bevorzugten Ausgestaltung erzeugt der Sensor ein Sensorsignal in Abhängigkeit eines auf den Sensor einfallenden Lichtes, wobei die Änderung des Sensorsignals einen sprunghaften oder stetigen Anstieg der Sensorsignalamplitude aufgrund eines erhöhten Lichteinfalls ist. Der Sensor ist dabei bevorzugt ein Lichtsensor, auch als Fotosensor oder Fotodetektor bezeichnet. Mit einem derartigen Lichtsensor kann die Intensität von Licht mit geeigneter Wellenlänge gemessen werden. Der Sensor wandelt Licht mittels eines photoelektrischen Effekts in ein elektrisches Signal um oder zeigt einen von der einfallenden Strahlung abhängigen elektrischen Widerstand. Da die Vorrichtung im Inneren des Mastes angeordnet ist, ist im Normalbetrieb das Innere des Mast nicht zugänglich, beispielsweise durch eine verschlossene Mast-Tür oder Mastklappe, sodass im Normalbetrieb ein definierter nahezu konstanter, geringer Lichteinfall vom Sensor detektiert wird. Beim Öffnen des Mastes, beispielsweise durch Betätigen einer Masttür oder Mastklappe, steigt der Lichteinfall sprunghaft an. Der Sensor detektiert diesen Anstieg und alarmiert die entfernte Netzwerkkomponente.

In einer bevorzugten Ausgestaltung umfasst das Auswerten des Sensorsignals eine Mittelung der Werte des Sensorsignals über eine vordefinierte Zeitdauer (sogenannte Minihysterese). Auf diese Weise können kurzzeitige Schwankungen der zu erfassenden physikalischen Eigenschaft ausgemittelt werden. So wird beispielsweise ein Lichtblitz (Gewitter etc.) in der Nähe des Mastes nicht zwangsläufig das (Fehl-) Alarmieren der entfernten Netzwerkkomponente aufgrund abnormal hohem Lichteinfall auslösen. So wird beispielsweise ein Windstoß (Sturm etc.) am Mast nicht zwangsläufig das (Fehl-) Alarmieren der entfernten Netzwerkkomponente aufgrund abnormaler Bewegung des Gehäuses auslösen.

In einer weiter bevorzugten Ausgestaltung ist der Sensor ein Bewegungssensor, wobei die Änderung des Sensorsignals einen sprunghaften oder stetigen Anstieg der Sensorsignalamplitude aufgrund eines Bewegens des Gehäuses der Vorrichtung ist. Der Bewegungssensor ist dabei beispielsweise ein Beschleunigungssensor, ein Neigungssensor oder ein Global Positioning System, GPS, Sender. Im Normalbetrieb ist die elektronische Komponente in der Außenbereichsvorrichtung stationären Mast fixiert und somit keiner Bewegung ausgesetzt. Der Bewegungssensor detektiert jegliche Bewegung des Gehäuses, beispielsweise wenn ein Angreifer versucht, Anschlüsse der Vorrichtung zu manipulieren oder ein Dieb die Vorrichtung entwenden möchte. Sodann erfolgt das Alarmieren der entfernten Netzwerkkomponente.

In einer weiter bevorzugten Ausgestaltung ist der Sensor ein Schaltelement, wobei die Änderung des Sensorsignals einen sprunghaften oder stetigen Anstieg der Sensorsignalamplitude aufgrund eines Öffnens des Gehäuses der elektronischen Komponente ist. Dabei ist das Schaltelement derart im oder am Gehäuse angeordnet, dass ein Öffnen des Gehäuses die Änderung eines Schaltzustands bewirkt. Das Schaltelement ist beispielsweise ein Mikroschalter oder ein Reed-Kontakt oder ein Magnetkontakt vorgesehen.

Die Kontrolleinheit der elektronischen Komponente ist in einer bevorzugten Ausgestaltung dazu eingerichtet, zumindest sicherheitsrelevante Informationen, die in einem Speicher der Vorrichtung abgelegt sind, zu löschen und/oder zu überschreiben, wenn die Änderung des Sensorsignals durch die Kontrolleinheit der elektronischen Komponente erkannt wird. In einer verbesserten Ausgestaltung wird der gesamte Speicherinhalt der elektronischen Komponente gelöscht oder überschrieben. Dies erhöht die Sicherheit weiter, da nun bei einer erkannten Abnormalität, erkannt durch die Sensorsignaländerung, die sicherheitsrelevanten Informationen der elektronischen Komponente gelöscht werden. In der Folge wird keine Datenverbindung weitergeleitet werden und jedes Peripheriegerät verliert die Datenverbindung zur entfernten Netzwerkkomponente. Bevorzugt wird auch die Energieversorgung zu den Peripheriegeräten (=elektrische Funktionseinheit) durch die Kontrolleinheit der elektronischen Komponente deaktiviert, sodass kein Zugriff auf die Daten der Peripheriegeräte mehr möglich ist.

Die vertraulichen bzw. sicherheitsrelevanten Informationen betreffen einerseits Konfigurationsinformationen der elektronischen Komponente, insbesondere IP-Adressen zur entfernten Netzwerkkomponente, private kryptographische Schlüssel der elektronischen Komponente, Zertifikate der elektronischen Komponente, Signaturschlüssel der elektronischen Komponente, eine Konfigurationsdatei mit Verbindungsparametereinstellungen oder andererseits Zugriffspasswörter, Konfigurationspasswörter, Black-Listen der bzw. von anderen elektronischen Komponente, White-Listen der bzw. von anderen elektronischen Komponente,

Zugriffseinstellungen und dergleichen mehr. Auch Benutzernamen und Benutzerpasswörter zur Authentifizierung am Peripheriegerät zählen zu den sicherheitsrelevanten Informationen Die elektronische Komponente ist damit vollständig unkonfiguriert und kann so weder eine Datenverbindung zur entfernten Netzwerkkomponente herstellen noch eine Datenverbindung zu/von einem Peripheriegerät weiterleiten. Eine Manipulation durch Datenabgriff oder Peripheriegerätefernsteuerung ist somit ausgeschlossen.

In einer weiter bevorzugten Ausgestaltung ist die Kontrolleinheit der elektronischen Komponente dazu eingerichtet, die sicherheitsrelevanten Informationen erst zu löschen und/oder zu überschreiben, wenn die Änderung des Sensorsignals einen sprunghaften oder stetigen Anstieg der Sensorsignalamplitude aufgrund des Öffnens des Gehäuses der elektronischen Komponente und/oder aufgrund eines Bewegens des Gehäuses der elektronischen Komponente ist. Das Bewegen der elektronischen Komponente oder auch das Öffnen des Gehäuses der elektronischen Komponente wird stets als Angriff gewertet und somit das Löschen erzwungen. Nach dem Öffnen des Gehäuses oder dem Bewegen des Gehäuses ist die elektronische Komponente vollständig unkonfiguriert und kann so weder eine Datenverbindung zur entfernten Netzwerkkomponente herstellen noch eine Datenverbindung zu/von einem Peripheriegerät weiterleiten. Eine Manipulation durch Datenabgriff oder Peripheriegerätefernsteuerung ist somit ausgeschlossen.

Es ist bevorzugt vorgesehen, zumindest zwei Sensoren vorgesehen. Damit kann eine Redundanz an Sensorsignalen ausgenutzt werden, um einen Angriff auf die Vorrichtung sicherer zu erkennen. Zudem kann auch ein zweistufiges Alarmieren geschaffen werden, beispielsweise wird bei Erkennen einer Sensoramplitude des ersten Sensors oberhalb eines Sensorsignalschwellwertes zunächst (nur) die entfernte Netzwerkkomponente alarmiert und bei Erkennen einer Sensoramplitude des zweiten Sensors oberhalb eines Sensorsignalschwellwertes werden weitere Maßnahmen in der elektronischen Komponente selbst getroffen, beispielsweise das Löschen bzw. das Überschreiben sensibler Informationen.

In einer bevorzugten Ausgestaltung umfasst die elektronische Komponente weiter einen Energiespeicher zum Bereitstellen einer Versorgungsenergie für die Kontrolleinheit der elektronischen Komponente bei Wegfall oder Entfernen einer vorrichtungsexternen Energieversorgung. Somit wird eine Funktion des Sensors der elektronischen Komponente weiter sichergestellt und zusätzlich auch Energie zum Löschen bzw. Überschreiben des Speichers der elektronischen Komponente garantiert. Somit wird auch bei einem Abklemmen der elektronischen Komponente bei Diebstahl oder Wartung eine Betriebsbereitschaft auch ohne Versorgungsenergie ermöglicht.

Das Löschen bzw. das Überschreiben werden auch als "Zeroize" bezeichnet.

In einer weiter bevorzugten Ausgestaltung weist die elektronische Komponente eine Energieversorgungseinheit auf. Die Energieversorgungseinheit weist einen ersten Energieanschluss (beispielsweise der erste Datenanschluss oder ein zusätzlicher Anschluss) zum Zuführen einer komponentenexternen Versorgungsenergie auf. Die Energieversorgung weist zumindest einen zweiten Energieanschluss zum Abgreifen einer Versorgungsenergie für das Peripheriegerät auf, wobei der zweite Energieanschluss ein Power-on-Ethernet, PoE, Energiesignal bereitstellt, das mit dem zu übertragenden Datensignal zwischen der elektronischen Komponente und dem Peripheriegerät zusammengeführt wird. Auf diese Weise ist ein Versorgen jedes Peripheriegeräts und auch jeder elektrischen Funktionseinheit der Außenbereichsvorrichtung über einen der zweiten Datenanschlüsse der elektronischen Komponente möglich, wodurch ein Verkabelungsaufwand im Mast reduziert wird und auf das Bereitstellen einer zusätzlichen Energieversorgung der Peripheriegeräte verzichtet wird. Die Energieversorgung ist weiter bevorzugt ein Netzteil, dessen Energieverbrauch überwacht und protokolliert wird. Auf diese Weise können Abnormalitäten der Vorrichtung selbst oder auch der Peripheriegeräte erkannt und der entfernten Netzwerkkomponente gemeldet werden.

In einer bevorzugten Ausgestaltung weist die Energieversorgungseinheit der elektronischen Komponente zumindest einen dritten Energieanschluss zum Abgreifen einer Versorgungsenergie für die Kontrolleinheit der elektronischen Komponente auf. Somit wird die Energie für die Kontrolleinheit der elektronischen Komponente durch die elektronische Komponente selbst aufbereitet und muss nicht von extern bereitgestellt werden.

In einer weiter bevorzugten Ausgestaltung ist die Kontrolleinheit der elektronischen Komponente auf einer Leiterplatine mit Standardformfaktor, bevorzugt PC/104, angeordnet, wobei noch weiter bevorzugt die Energieversorgungseinheit der elektronischen Komponente auf einer zweiten Leiterplatine mit Standardformfaktor, bevorzugt PC/104, angeordnet ist. Dieser Industriestandard ermöglicht das Miniaturisieren der elektronischen Komponente, sodass diese in die Außenbereichsvorrichtung angeordnet werden kann, ohne bauliche Veränderungen daran vornehmen zu müssen. Zudem ist dieser Formfaktor geeignet, eine große Oberfläche für Komponenten der Vorrichtung bereitzustellen, sodass eine gute Wärmeableitung erfolgen kann. Die Wahl eines gleichen Formfaktors ermöglicht zudem ein Anordnen mehrerer Platinen übereinander, ein sogenanntes "Stacking" und Verbinden mittels Steckverbinder. Damit wird die elektromagnetische Verträglichkeit der Komponenten auf der Platine untereinander verbessert.

In einer bevorzugten Ausgestaltung erfolgt ein Authentifizieren des Peripheriegeräts zum Weiterleiten der Datenkommunikation zwischen der entfernten Netzwerkkomponente und dem Peripheriegerät auf Basis der MAC Adresse des Peripheriegeräts, wobei weiter bevorzugt bei fehlgeschlagener Authentifizierung des Peripheriegeräts das Weiterleiten der Datenkommunikation von der Kontrolleinheit der elektronischen Komponente unterbunden wird. Dabei folgt die Datenkommunikation bevorzugt dem IEEE 802.1x Protokoll und ermöglicht eine abgesicherte Kommunikation. Die MAC-Adresse des Peripheriegeräts ist bevorzugt in der entfernten Netzwerkkomponente bekannt gemacht worden. Durch diese Absicherung ist ein an der elektronischen Komponente eingerichtetes Peripheriegerät nicht austauschbar, ein anderes Peripheriegerät am zweiten Datenanschluss führt zu einer Deaktivierung der Datenverbindung zum Peripheriegerät.

### KURZE BESCHREIBUNG DER FIGUREN

Nachfolgend wird anhand von Figuren die Erfindung bzw. weitere Ausführungsformen und Vorteile der Erfindung näher erläutert, wobei die Figuren lediglich Ausführungsbeispiele der Erfindung beschreiben. Gleiche Bestandteile in den Figuren werden mit gleichen Bezugszeichen versehen. Die Figuren sind - bis auf speziell gekennzeichnete Ausnahmen - nicht als maßstabsgetreu anzusehen, es können einzelne Elemente der Figuren übertrieben groß bzw. übertrieben vereinfacht dargestellt sein.
Fig. 1A-C zeigt ein Ausführungsbeispiel einer erfindungsgemäßen Außenbereichsvorrichtung mit verschließbarer Öffnung und einer elektronischen Komponente im Hohlraum der Außenbereichsvorrichtung;
Fig. 2a-d zeigt verschiedene Ansichten eines Ausführungsbeispiels eines erfindungsgemäßen Komponentengehäuses einer elektronischen Komponente;
Fig. 3 zeigt eine perspektivische Ansicht eines Ausführungsbeispiels eines erfindungsgemäßen Komponentengehäuses einer elektronischen Komponente in Explosivdarstellung ohne elektrische Komponenten;
Fig. 4a-d zeigt verschiedene Ansichten eines zweiten Seitenteils des in Fig. 2 und 3 dargestellten Komponentengehäuses einer elektronischen Komponente;
Fig. 5 zeigt eine perspektivische Ansicht eines ersten Seitenteils des in Fig. 2 und 3 dargestellten Komponentengehäuses einer elektronischen Komponente;
Fig. 6A-C zeigt verschiedene Ansichten eines Bodens des in Fig. 2 und 3 dargestellten Komponentengehäuses einer elektronischen Komponente;
Fig. 7a-d zeigt verschiedene Ansichten eines Deckels des in Fig. 2 und 3 dargestellten Komponentengehäuses einer elektronischen Komponente;
Fig. 8 zeigt eine perspektivische Ansicht eines Ausführungsbeispiels eines erfindungsgemäßen Komponentengehäuses einer elektronischen Komponente in Explosivdarstellung mit elektrischen Komponenten;
Fig. 9a-d zeigt eine erfindungsgemäße Variante zur mechanischen Fixierung eines Komponentengehäuses einer elektronischen Komponente in einer Außenbereichsvorrichtung;
Fig. 10 zeigt ein Ausführungsbeispiel eines vereinfachten Blockschaltbilds einer erfindungsgemäßen elektronischen Komponente innerhalb eines schematisch dargestellten Mast-Abschnitts;
Fig. 11 zeigt ein Ausführungsbeispiel eines vereinfachten Blockschaltbilds einer erfindungsgemäßen elektronischen Komponente;
Fig. 12 zeigt ein Ausführungsbeispiel eines vereinfachten Blockschaltbilds einer erfindungsgemäßen elektronischen Komponente;
Fig. 13 zeigt ein maßstabsgetreues Ausführungsbespiel eines beispielhaften Mastes, in den eine erfindungsgemäße elektronische Komponente angeordnet wird;
Fig. 14 zeigt drei maßstabsgetreue Ausführungsbespiele für beispielhafte Mastöffnungen, durch die hindurch eine erfindungsgemäße elektronische Komponente in einen Mast angeordnet wird; und
Fig.15 zeigt ein Ausführungsbespiel eines erfindungsgemäßen Systems aus Mast mit darin angeordneter elektronischer Komponente.

### DETAILLIERTE BESCHREIBUNG VON AUSFÜHRUNGSBEISPIELEN

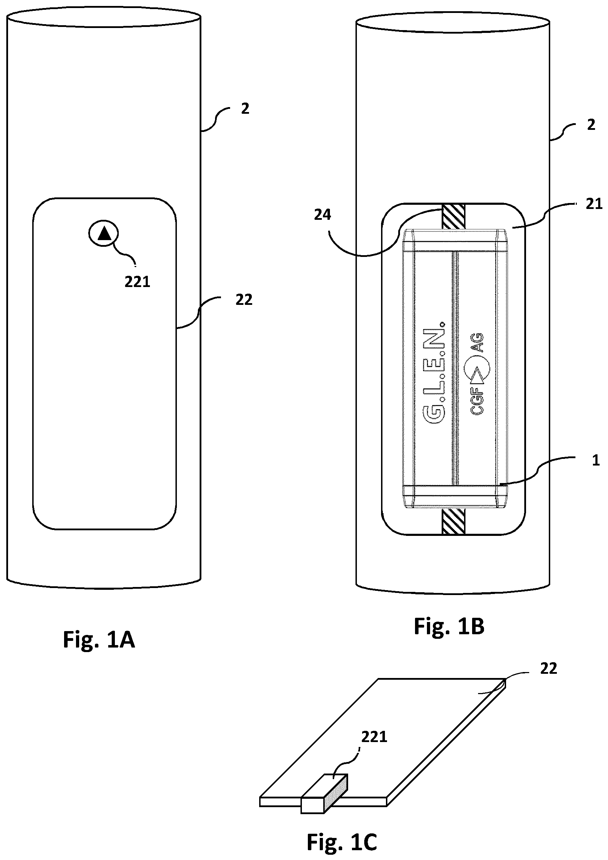

Die Figuren 1A-C zeigen ein Ausführungsbeispiel einer erfindungsgemäßen Außenbereichsvorrichtung 2 mit verschließbarer Öffnung 21 und einer elektronischen Komponente 1 im Hohlraum der Außenbereichsvorrichtung 2.

Fig. 1A zeigt dabei die Außenbereichsvorrichtung 2 als Teilabschnitt eines Mastes 2. Der Mast 2 hat eine Öffnung, die mittels Klappe bzw. Tür 22 durch einen Verschlusselement 221 der Klappe 22 verschlossen wird. Das Verschlusselement 221 bedient einen mechanischen Hebel (siehe Fig. 1C) und wird über einen dreikantigen Schlüssel bedient.

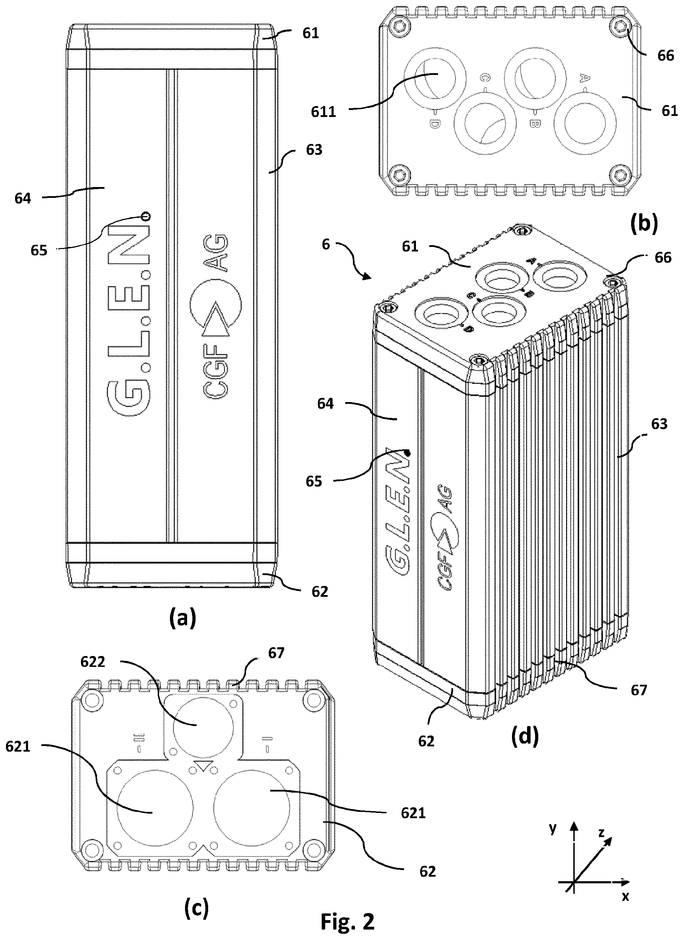

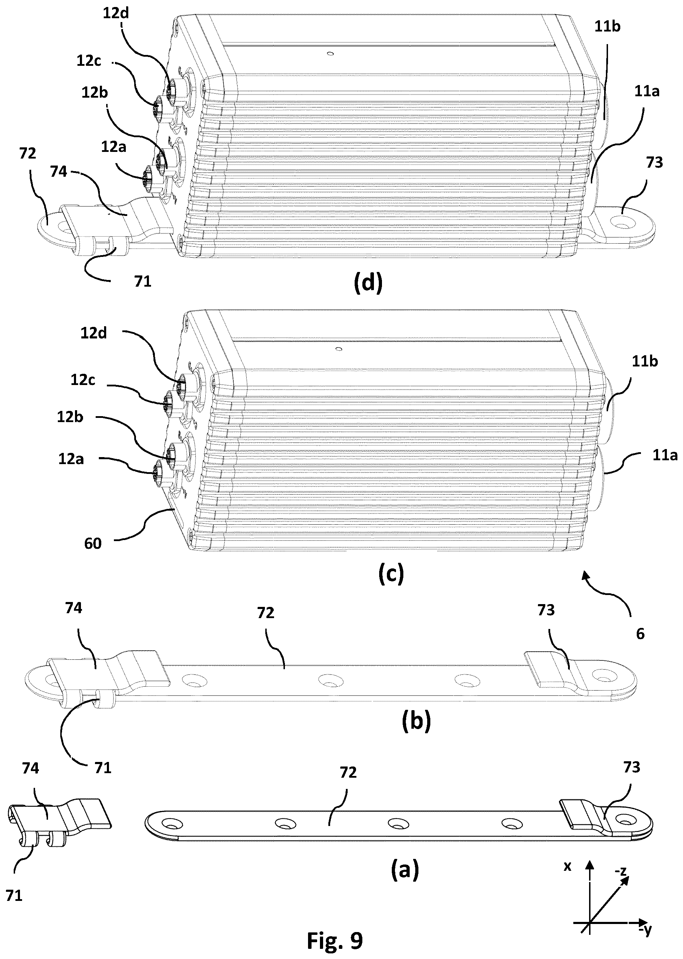

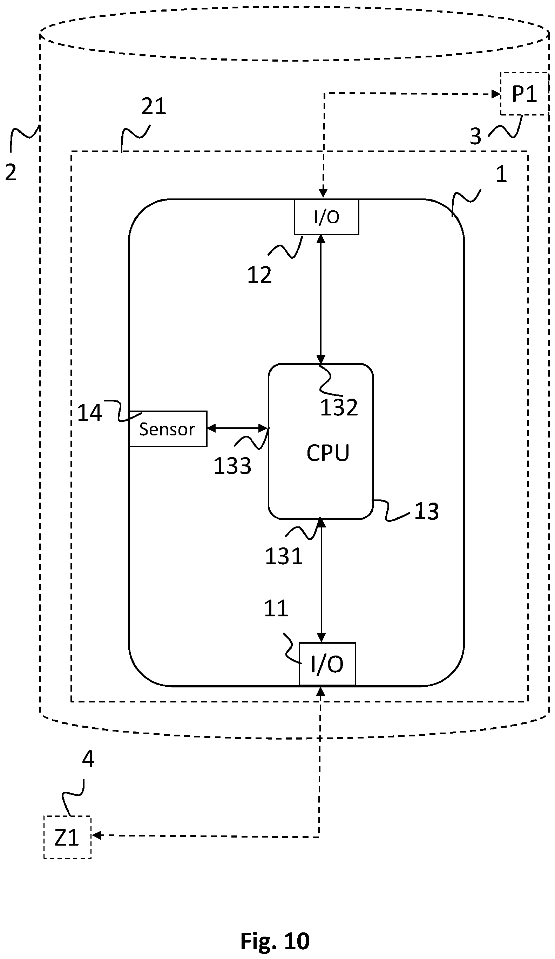

Die Fig. 1B zeigt den in Fig. 1A dargestellten Mast 2 mit entfernter Tür 22. Der Mast 2 ist hohl und beherbergt eine elektronische Komponente 1, die in den Fig. 10 bis 12 detailliert eingegangen wird. Die elektronische Komponente 1 ist an einem Befestigungselement 24 mechanisch fixiert in dem Hohlraum des Mastes 2 angeordnet. Die Fig. 1B zeigt keine elektrischen Verbindungen, auf diese wird ausführlich in den Fig. 10 bis 12 eingegangen. In Fig. 1B ist zu erkennen, dass die elektronische Komponente 1 ein Komponentengehäuse aufweist. Diese Komponentengehäuse wird in den Fig. 2 bis 8 ausführlich gezeigt und beschrieben. Das Komponentengehäuse ist ein Kühlkörper für die elektronische Komponente 1. Das Komponentengehäuse ist (in Fig. 1B andeutungsweise dargestellt) vollständig beabstandet von der runden Innenseite des Masts 2 fixiert. Eine Befestigungsvariante wird in Fig. 9 vorgestellt.

Diese Anordnung gemäß Fig. 1B ermöglicht eine Luftumströmung der elektronischen Komponente 1 an jeder ihrer Oberseiten und ermöglicht so, eine effiziente Wärmeableitung von der durch die elektronischen Komponenten 1 erzeugten Wärme. Diese Anordnung ermöglicht einen Betrieb der elektronischen Komponente 1 im Mast 2 ohne zusätzliche Kühlmaßnahmen, wie beispielsweise einer Heat-Pipe, eines Lüfters oder gar einer Wasserkühlung. Eine Schlotwirkung des Mastes 2 sorgt für eine ausreichende Umströmung der elektronischen Komponente 1 zum Wärmeabtransport. Durch das zentrale Anordnen im Mast 2 können alle Oberseiten der elektronischen Komponente 1 gleichermaßen umströmt werden.

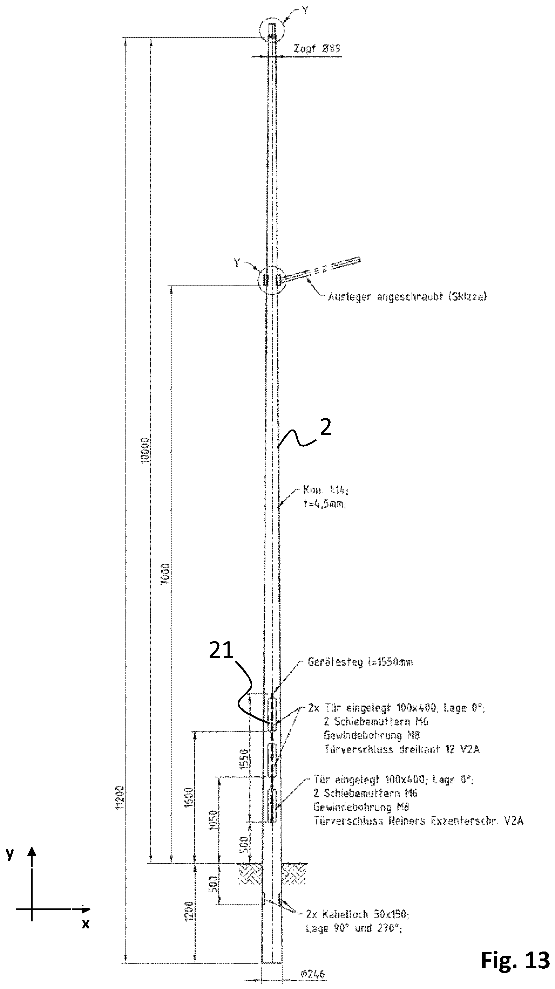

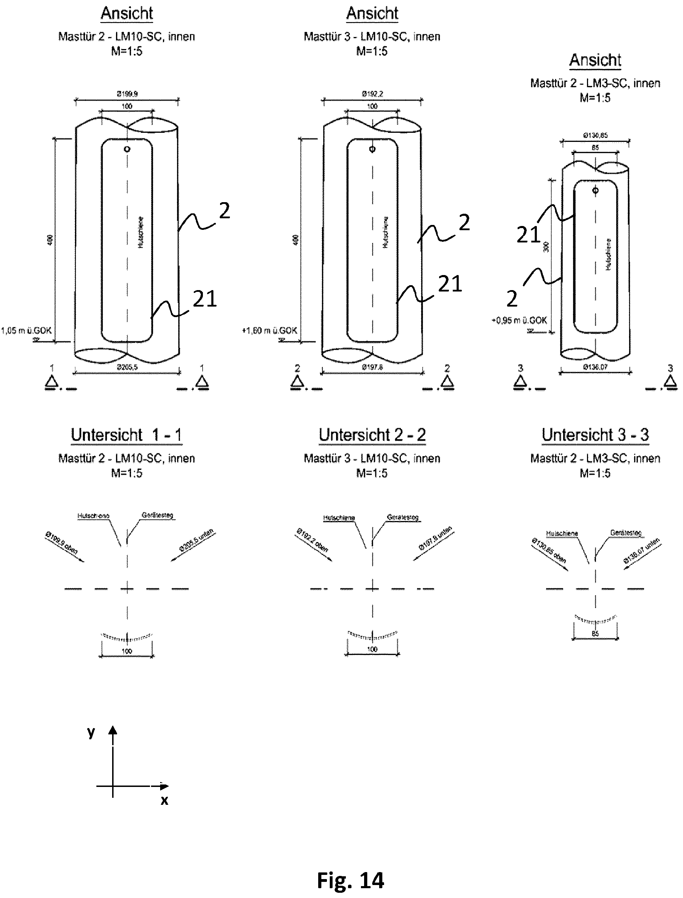

Über die Öffnung 21 kann die elektronische Komponente 1 in den Hohlraum eingebracht (installiert) und auch wieder entnommen werden (deinstalliert). Die Maße der Öffnung bestimmen als die Abmaße des Komponentengehäuses, was durch die maßstabsgetreuen Zeichnungen der Fig. 13 und 14 mit offenbart ist.

In Fig. 1C ist die Tür 22 des Masts 2 dargestellt. Diese Tür 22 verschließt die Öffnung 21 im Betrieb der elektronischen Komponente 1. Das Verschließen wird über den Verschlusshebel 221 und einem dreikantigen Schlüssel ermöglicht. Der Mast 2 ist damit ein konventioneller Mast, der mit der elektronischen Komponente 1 nachgerüstet wird.

Der in Fig. 1A bis C gezeigte Mast 2 mit Tür 22 ist in den Fig. 13 bis 15 detailliert dargestellt und es wird auf die entsprechende Beschreibung verwiesen.

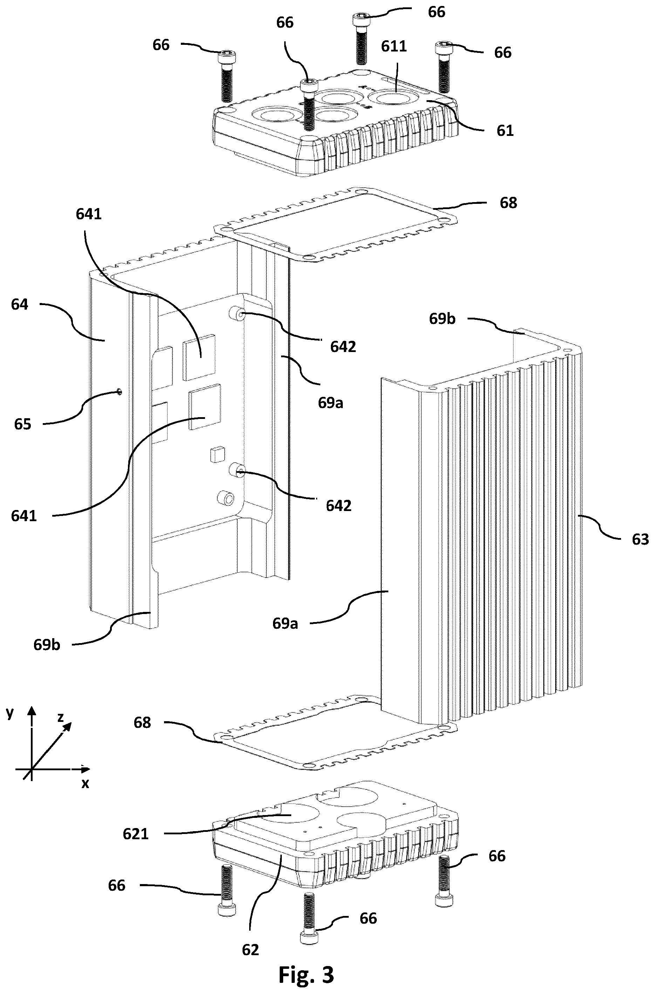

Die Figuren 2a-d zeigen vier verschiedene Ansichten eines Ausführungsbeispiels eines erfindungsgemäßen Komponentengehäuses 6 einer in den Fig. 1 und Fig. 10 bis 12 beschriebenen elektronischen Komponente 1. In Fig. 2 (a) ist eine Seitenansicht des Gehäuses 6 gezeigt. Zu erkennen ist ein vierteiliger Aufbau des Gehäuses 6, bestehend aus einem Deckel 61, einem Boden 62, einem ersten Seitenteil 63 und einem zweiten Seitenteil 64. Auf die einzelnen Teile 61 bis 64 wird in den Figuren 3 bis 7 genauer eingegangen. Angedeutet ist ein Teilbereich 65 im zweiten Seitenteil 64, hinter dem ein Sensor angeordnet wird, um einen Angriff auf die elektronische Komponente 1 zu erkennen.

In Fig. 2 (b) ist eine Draufsicht auf das Gehäuse 6 dargestellt. In der Draufsicht ist die äußere Struktur des Deckels 61 des Gehäuses 6 gut zu erkennen. Der Deckel 61 weist vier Durchbohrungen 611 auf. In jede dieser Durchbohrungen 611 wird ein zweiter Datenanschluss der elektronischen Komponente 1 platziert werden. Zudem sind am Deckel 61 des Gehäuses 6 Kühlrippen angedeutet, die eine Oberflächenvergrößerung bewirken und so, den Wärmeabtransport verbessern. Zudem sind am Deckel 61 des Gehäuses 6 vier Schrauben 66 dargestellt, mit denen der Deckel 61 mit den Seitenteilen 63 und 64 des Gehäuses 6 mechanisch lösbar verbunden ist.

In Fig. 2 (c) ist eine Draufsicht auf den Boden 62 des Gehäuses 6 dargestellt. In dieser Ansicht ist die äußere Struktur des Bodens 62 des Gehäuses 6 gut zu erkennen. Der Boden 62 weist drei Durchbohrungen 621 und 622 auf. Zwei Durchbohrungen 621 werden für erste Datenanschlüsse der elektronischen Komponente 1 vorgesehen. Ein weitere Durchbohrung 622 dient einem Energieanschluss. Zudem sind am Boden 62 des Gehäuses 6 Kühlrippen 67 angedeutet, die eine Oberflächenvergrößerung bewirken und so, den Wärmeabtransport verbessern. Zudem sind am Boden 62 des Gehäuses 6 vier Schrauben dargestellt, mit denen der Boden 62 mit den mit den Seitenteilen 63 und 64 des Gehäuses 6 mechanisch lösbar verbunden ist.

In Fig. 2 (d) ist eine perspektivische Ansicht des Gehäuses 6 dargestellt. In dieser Ansicht ist die äußere Struktur des ersten Seitenteils 63 des Gehäuses 6 gut zu erkennen. Insbesondere sind Kühlrippen 67 an der Außenseite des ersten Seitenteils 63 des Gehäuses 6 dargestellt, die eine Oberflächenvergrößerung bewirken und so, den Wärmeabtransport verbessern. Die Kühlrippen 67 verlaufen ununterbrochen parallel zur Längsachse in y-Richtung und sind über der gesamten Außenfläche des ersten Seitenteils 63 gezeigt. Angedeutet aber nicht gezeigt sind ebenfalls Kühlrippen 67 am zweiten Seitenteil 64 des Gehäuses 6. Angedeutet ist auch die Durchbohrung 65 für einen Sensor im zweiten Seitenteil 64.

Durch das Einbauen des Komponentengehäuses 6 in Längsrichtung des Mastes 2, so wie es in Fig. 1C gezeigt ist, wird Wärme, die im Inneren des Komponentengehäuses 6 erzeugt wird, an die Außenflächen des Komponentengehäuses 6 weitergeleitet und dort durch die Kühlrippen 67 oberflächenverteilt. Die Anordnung der Kühlrippen 67 quasi-parallel zur Längsausrichtung des Mastes 2 verbessert den Wärmeabtransport, beispielsweise bei kälterer Luft im Hohlraum des Mastes 2.

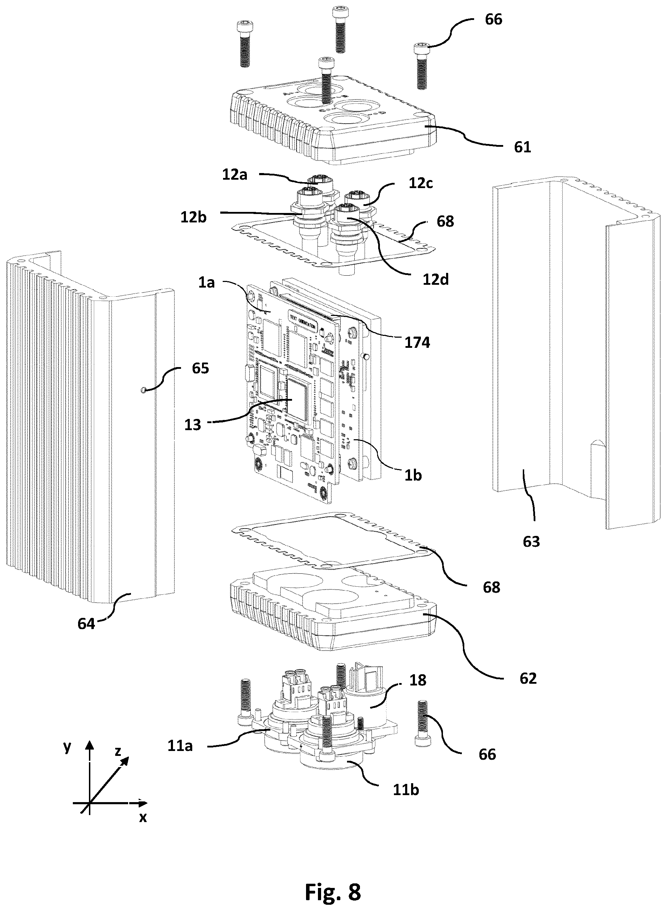

Die Fig. 3 zeigt eine perspektivische Ansicht eines Ausführungsbeispiels eines erfindungsgemäßen Komponentengehäuses 6 einer elektronischen Komponente 1 in zerlegter Form (sogenannte Explosivdarstellung) ohne die elektronisch Komponente 1 (im Unterschied zur Fig. 8). Im Unterschied zur Fig. 2(d) ist nun das Komponentengehäuse 6 auch von Innen dargestellt. Für die äußeren Merkmale des Komponentengehäuses 6 wird auf die vorhergehende Beschreibung der Fig. 2 verwiesen.

Die innere Oberseite des zweiten Seitenteils 64 des Komponentengehäuses 6 zeigt 5 Erhebungen 641, die in das Innere des Komponentengehäuses hineinragen. Diese Erhebungen 641 kontaktieren entsprechende Bauelemente einer Leiterplatine (nicht dargestellt) direkt (ggf. über weitere Elemente, wie Wärmepaste oder Wärmeleitplättchen). Diese Leiterplatine beherbergt eine Kontrolleinheit der elektronischen Komponente. Diese Kontrolleinheit ist eine große Wärmequelle und muss im Betrieb der elektronischen Komponente gekühlt werden. Durch das Ausbilden der Innenseite des zweiten Seitenteils 64 mit den Erhebungen 641 wird eine gute Wärmebrücke (Wärmekopplung) erzielt. Das gesamte zweite Seitenteil 64 ist aus Aluminium und bildet einen massiven Kühlkörper für die elektronische Komponente 1. Die innere Oberseite des zweiten Seitenteils 64 des Komponentengehäuses 6 zeigt zudem 2 (von vier) Befestigungshülsen 642, mittels derer die Platine mechanisch lösbar mit dem zweiten Seitenteil 64 fixiert wird. Diese Fixierung erhöht die Wärmekopplung weiter.

In Fig. 3 sind zudem acht Schrauben 66 des Gehäuses 6 dargestellt, mit denen die vier Teile 61 bis 64 des Gehäuses 6 miteinander verbunden werden. Zwischen den Boden 62 und den zwei Seitenteilen 63, 64 des Gehäuses 6 wird eine Dichtung 68 platziert. Zwischen den Decke 61 und den zwei Seitenteilen 63, 64 des Gehäuses 6 wird eine zweite Dichtung 68 platziert. Das erste Seitenteil 63 weist eine erste Verbindungslippe 69a auf, die mit einer zweite Verbindungslippe 69b des zweiten Seitenteils 64 korrespondiert. Das erste Seitenteil 63 weist eine zweite Verbindungslippe 69b auf, die mit einer ersten Verbindungslippe 69a des zweiten Seitenteils 64 korrespondiert. Diese Verbindungslippen 69a und 69b ermöglichen ein Zusammenstecken der Seitenteile 63, 64 und erhöhen damit die Stabilität des Gehäuses 6 und die elektromagnetische Verträglichkeit, EMV des Gehäuses. Durch die Dichtungen 68 und die Verbindungslippen 69a,

69b wird eine hohe Schutzart, beispielsweise Schutzart IP67, des Gehäuses 6 erreicht. Diese hohe Schutzart garantiert einen Spritzwasserschutz der elektronischen Komponente 1. Somit kann der Mast 2 mittels Wasser hochdruckgereinigt werden, ohne dass die elektronische Komponente 1 Schaden nimmt.

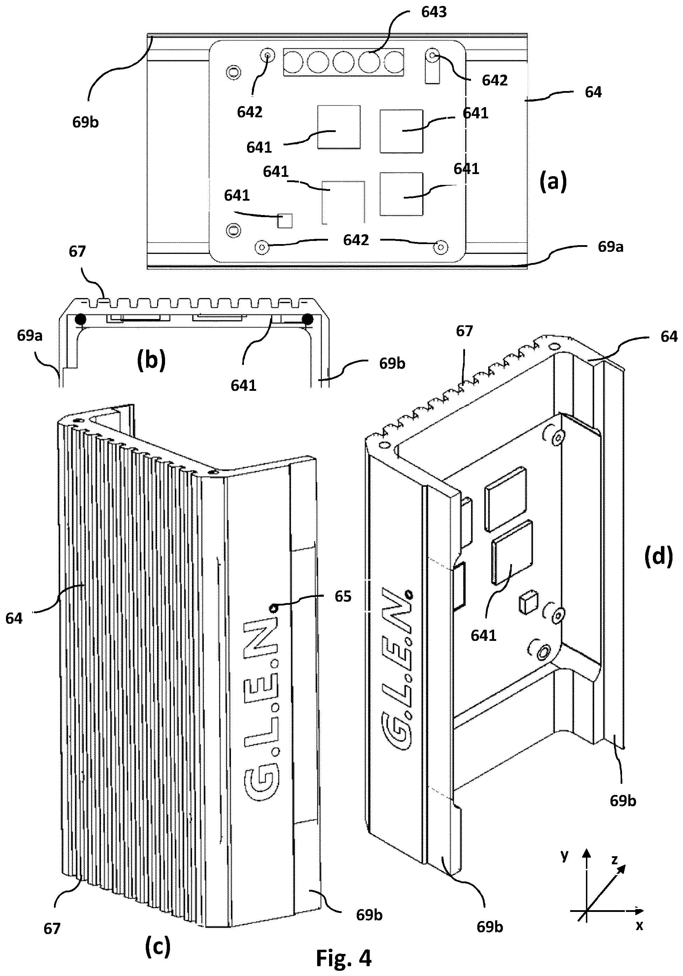

In den Figuren 4a-d sind vier verschiedene Ansichten des zweiten Seitenteils 64 des in Fig. 2 und 3 dargestellten Komponentengehäuses 6 einer elektronischen Komponente 1 gezeigt.

In Fig. 4(a) ist dabei eine Innendraufsicht auf das zweite Seitenteil 64 dargestellt. Dabei sind wieder die in Fig. 3 bereits beschriebenen Erhebungen 641 und Befestigungshülsen 642 gezeigt. Zudem ist ein Bereich 64 dargestellt.

In Fig. 4(b) ist dabei Draufsicht auf das zweite Seitenteil 64 dargestellt. Dabei sind wieder Kühlrippen 67 und die beiden Verbindungslippen 69a, 69b gezeigt. In dieser Darstellung ist der Unterschied der Dicke zwischen der ersten Verbindungslippe 69a und der zweiten Verbindungslippe 69b gut zu erkennen. Dieser Dickenunterschied ermöglicht das einfache und stabile Ineinanderstecken der beiden Seitenteile 63 und 64 des Gehäuses 6.

Die Fig. 4 (c) zeigt eine Außenfläche des zweiten Seitenteils 64. Zu erkennen ist auch hier, dass Kühlrippen 67 ununterbrochen parallel zu einer Längsachse y der ausgebildet sind, um eine optimale Kühlung der elektronischen Komponente 1 zu ermöglichen. Speziell durch die Schlotwirkung eines Mastes 2 wird so, die Wärme zügig von der jeweiligen Wärmequelle abtransportiert.

Die Fig. 4 (d) zeigt nochmal die Innenansicht des zweiten Seitenteils mit den Erhebungen 641 und den Befestigungshülsen 642, wie es bereits mit Bezug auf Fig. 3 dargestellt und beschrieben wurde.

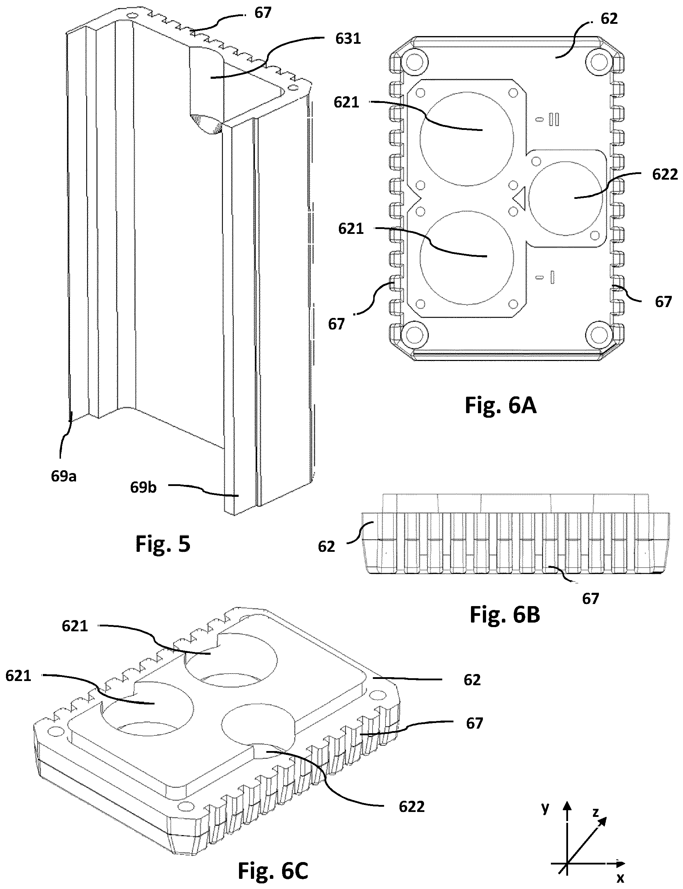

Die Fig. 5 zeigt eine perspektivische Ansicht des ersten Seitenteils 63 des in Fig. 2 und 3 dargestellten Komponentengehäuses 6 der elektronischen Komponente 1. Das erste Seitenteil 63 weist innen eine Ausnehmung 631 zur Aufnahme eines Energieanschlusses 18 (nicht dargestellt) auf. Ebenfalls sind die erste Verbindungslippe 69a und die zweite Verbindungslippt 69b dargestellt, die zu den entsprechenden Verbindungslippen 69a, 69b des zweiten Seitenteils 64 korrespondieren.

Die Figuren 6A-C zeigen drei Ansichten des Bodens 62 des in Fig. 2 und 3 dargestellten Komponentengehäuses 6 der elektronischen Komponente 1. Fig. 6A entspricht der Darstellung

der Fig. 2(c) und es wird auf die entsprechende Beschreibung verwiesen. Fig. 6B zeigt eine Frontdarstellung des Bodens 62 mit den Kühlrippen 67. Zu erkennen ist in Fig. 6B zudem eine Erhebung, um eine gute mechanische und stabile Verbindung mit den beiden Seitenteilen 63, 64 des Gehäuses 6 zu erhalten. Die Fig. 6C zeigt eine perspektivische Darstellung des Bodens 62 mit den drei Durchbohrungen 621, 622 für die Anschlüsse 11a, 11b und 18 der elektronischen Komponente 1. Ebenfalls sind Kühlrippen 67 angedeutet.

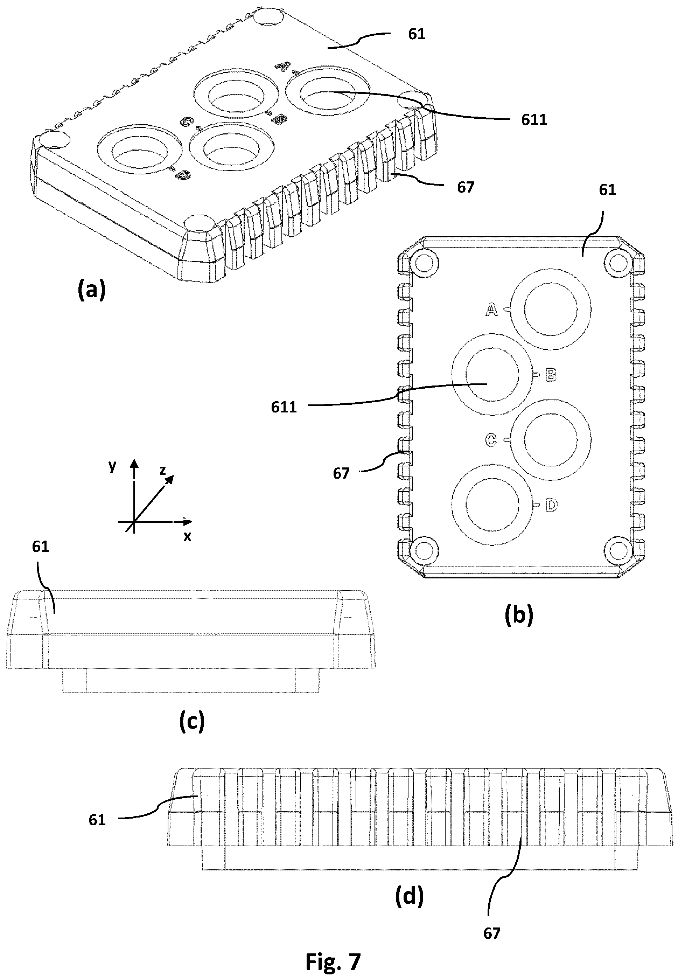

Die Figuren 7a-d zeigen vier verschiedene Ansichten des Deckels 61 des in Fig. 2 und 3 dargestellten Komponentengehäuses 6 der elektronischen Komponente 1.

Die Fig. 7(a) zeigt eine perspektivische Darstellung des Deckels 61 mit den vier Durchbohrungen 611 für die Anschlüsse 12a, 12b, 12c und 12d der elektronischen Komponente 1. Ebenfalls sind Kühlrippen 67 angedeutet. Zudem sind die Kühlrippen 67 angedeutet.

Die Fig. 7(b) entspricht der Darstellung der Fig. 2(b) und es wird auf die entsprechende Beschreibung verwiesen.

Die Fig. 7(c) zeigt eine Seitendarstellung des Deckel 61. Zu erkennen ist in Fig. 7(d) zudem eine Erhebung, um eine gute mechanische und stabile Verbindung mit den beiden Seitenteilen 63, 64 des Gehäuses 6 zu erhalten.

Die Fig. 7(d) zeigt eine Frontdarstellung des Deckel 61 mit den Kühlrippen 67. Zu erkennen ist in Fig. 7(d) zudem die Erhebung, um eine gute mechanische und stabile Verbindung mit den beiden Seitenteilen 63, 64 des Gehäuses 6 zu erhalten.

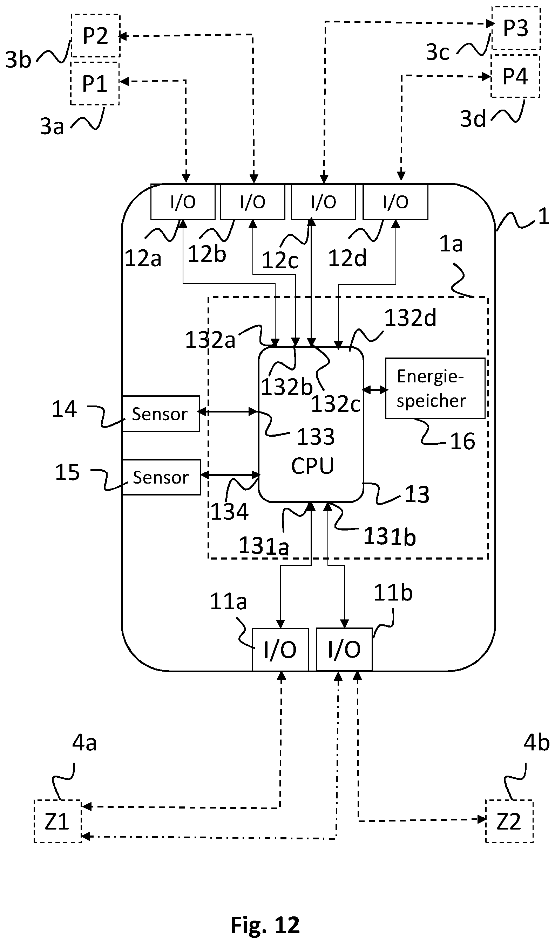

Die Fig. 8 zeigt eine perspektivische Ansicht des erfindungsgemäßen Komponentengehäuses 6 der elektronischen Komponente 1 gemäß Fig. 3 in zerlegter Form (Explosivdarstellung) jedoch diesmal mit der elektrischen Komponente1. Auf die in Fig. 3 bereits vorgestellten Elemente wird hier nicht wiederholend eingegangen. In den Deckel 61 des Gehäuses werden vier Anschlüsse 12a, 12b, 12d, 12d in die entsprechenden Durchbohrungen 611 eingebracht. Die Anschlüsse 12a, 12b, 12d, 12d sind entsprechend stabil gewählt, um Scherkräfte bei der Installation und Deinstallation in den Mast 2 aufnehmen zu können, ohne dass der jeweilige Anschluss zerstört wird. Die vier Anschlüsse 12a, 12b, 12d, 12d werden mit vier zweiten Datenanschlüssen 132a-132d (siehe Fig. 12) der ersten Platine 1a verbunden. Es wird auf die Beschreibung der elektrischen Funktion in den Fig. 10 bis 13 verwiesen.

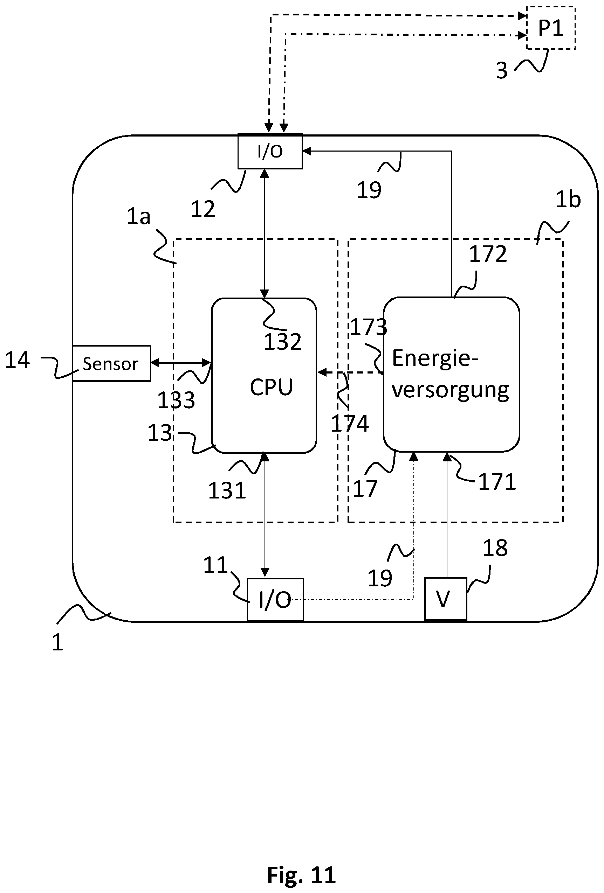

In den Boden 62 des Gehäuses werden zwei SFP-Anschlüsse 11a und 11b in die entsprechenden Durchbohrungen 621 eingebracht. Die SFP-Anschlüsse 11a und 11b sind entsprechend stabil gewählt, um Scherkräfte bei der Installation und Deinstallation in den Mast 2 aufnehmen zu können, ohne dass der jeweilige Anschluss zerstört wird. Die zwei Anschlüsse 11a, 11b werden mit zwei ersten Datenanschlüssen 131a, 131b (siehe Fig. 12) der ersten Platine 1a verbunden. Es wird auf die Beschreibung der elektrischen Funktion in den Fig. 10 bis 13 verwiesen. In den Boden 62 des Gehäuses wird ein Energie-Anschluss 18 in die entsprechende Durchbohrung 622 eingebracht. Der Anschluss 18 wird mit einem Energieanschluss 171 (siehe Fig. 11) der zweiten Platine 1b verbunden.

Die beiden Platinen 1a und 1b werden ebenfalls ausführlich in den Fig. 10 bis 13 beschrieben. Die Platinen 1a, 1b sind als PC/104 Formfaktor ausgebildet und mittels eines Verbindungssteckers 174 elektrisch leitend miteinander verbunden. Auf der ersten Platine 1a ist zudem die Kontrolleinheit 13 angedeutet.

Die Figuren 9a-d zeigen eine erfindungsgemäße Variante zum mechanischen Fixieren eines Komponentengehäuses 9 der elektronischen Komponente 1. In Fig. 9(a) ist dazu eine Halteschiene 72 dargestellt. Diese Halteschiene 72 hat ein erstes Halteelement 73, das mechanisch lösbar (geschraubt, nicht dargestellt) oder nicht lösbar (genietet, verschweißt, hier dargestellt) mit der Halteschiene 72 verbunden ist. Die Halteschiene 72 weist eine Vielzahl von Durchbohrungen auf, um mit einem Befestigungselement 24 (nicht dargestellt) der Fig. 1B mechanisch lösbar verbunden werden zu können. In Fig. 9 (a) ist zudem ein zweites Halteelement 74 gezeigt, welches mittels seitlich ausgeführten Klemmnasen (zwei pro Seite) eine Klemmverbindung 71 mit der Halteschiene 72 ermöglicht. In Fig. 9 (b) ist das zweite Haltelement 74 in y-Richtung beweglich auf die Halteschiene 72 montiert. Das zweite Haltelement 74 kann in y-Richtung auf der Halteschiene 72 bewegt werden und ermöglicht so eine mechanisch lösbare Fixierung des Komponentengehäuses 6 in dem Hohlraum des Mastes 2, wie in Fig. 9(c) und (d) dargestellt ist.

In Fig. 9(c) ist ein Haltebereich 60 in dem Gehäuse 6 gezeigt. Der Haltebereich 60 ist als Schlitz im Deckel 61 des Gehäuses 6 angeordnet. Nicht dargestellt ist ein zweiter Haltebereich 60, der als Schlitz im Boden 62 des Gehäuses 6 angeordnet ist. In diese Schlitze als Haltebereiche 60 greift ein entsprechender Bereich des ersten bzw. des zweiten Haltelements 74, siehe Fig. 9(d), wodurch die Halteschiene 72 (mechanisch mit einem Befestigungselement des Mastes 2 verbunden) mittels der Klemmverbindung 71 im Hohlraum des Mastes 2 fixiert ist.

Nicht dargestellt sind Rast- und/oder Schraub- und/oder Magnet- und/oder Klammerverbindungen, mit denen eine mechanische Fixierung im Hohlraum des Mastes 2 ebenfalls ermöglicht werden kann.

Fig. 10 zeigt ein Ausführungsbeispiel eines vereinfachten Blockschaltbilds einer erfindungsgemäßen elektronischen Komponente 1 innerhalb eines schematisch dargestellten Mast-Abschnitts eines Mastes 2 als Beispiel für eine Außenbereichsvorrichtung. Mit diesem Ausführungsbeispiel ist es möglich Masten 2 von Städten, Kommunen und Firmen zu Kommunikations- und Steuerknoten auszubauen und so ein Smart-City Konzept zu ermöglichen.

Der Mast 2 ist dabei ein Lichtmast, wie er beispielsweise in den nachfolgenden Figuren 13 bis 15 noch näher erläutert wird. Der Mast ist innen hohl und weist eine Mastöffnung 21 auf, die vorzugsweise durch eine Klappe bzw. Tür (nicht dargestellt) nahezu lichtdicht verschlossen werden kann. Im Inneren des Masts 2 befindet sich eine erfindungsgemäße elektronische Komponente 1, hier nachfolgend vereinfacht als Switch 1, also Netzwerkweiche bezeichnet.

Der Switch 1 wird in ein Metallgehäuse der Schutzart IP67 integriert. Der Switch 1 stellt eingangsseitig zumindest einen ersten Anschluss 11 bereit, der im Switch 1 an einen ersten Datenanschluss 131 einer Kontrolleinheit 13 angeschaltet ist. Der erste Datenanschluss 131 ist zum Übertragen eines Datensignals zwischen dem Switch 1 und einem vom Mast 2 entfernten Netzwerkkomponente, nachfolgend vereinfacht Rechenzentrum 4 oder Backbone 4 bezeichnet, eingerichtet. Das Datensignal am ersten Anschluss 11 hat beispielsweise eine Bitrate von 10 Gbit, könnte aber auch nur 1Gbit oder 100 Gbit haben. Das Rechenzentrum ist beispielsweise ein Stadt- oder Landesrechenzentrum, das mitunter mehrere hundert Kilometer vom Mast 2 entfernt ist. Das Netzwerk ist ein Metropolitan Area Network, kurz MAN. Bevorzugt wird das Datensignal über Lichtwellenleiter an den ersten Anschluss 11 angeschlossen. Das Datensignal kann dabei in einem Mono-Mode Verfahren übertragen werden, wenn die Entfernung zwischen Switch 1 und entfernter Netzwerkkomponente 4 einen bestimmten Schwellwert überschreitet. Das Datensignal kann dabei in einem Multi-Mode Verfahren übertragen werden, wenn die Entfernung zwischen Switch 1 und entfernter Netzwerkkomponente 4 einen bestimmten Schwellwert unterschreitet.

Ausgangsseitig hat der Switch 1 zumindest einen zweiten Anschluss 12, der im Switch 1 an einen zweiten Datenanschluss 132 der Kontrolleinheit 13 angeschaltet ist. Der zweite Datenanschluss 132 ist zum Übertragen eines Datensignals zwischen dem Switch 1 und Peripheriegerät 3 eingerichtet. Das Datensignal am zweiten Anschluss 12 ist beispielsweise eine 1 Gbit Ethernet Schnittstelle. Bevorzugt hat dieses Datensignal eine Power-On-Ethernet, PoE,

Funktionalität, über die eine vordefinierte, maximale Leistung, beispielsweise 25W, an das Peripheriegerät 3 übertragen werden können. Bevorzugt wird das Datensignal über Kupfer an den zweiten Anschluss 12 angeschlossen.

Der Switch 2 hat am Gehäuse einen Sensor 14 verbaut. Dieser Sensor 14 ist in Fig. 10 ein Lichtsensor, der an einen Sensorsignalanschluss 133 an die Kontrolleinheit 13 angeschlossen ist. Der Lichtsensor ist von Innen am Gehäuse des Switches 1 verbaut, um einfallendes Licht in die Mastöffnung 21 zu erfassen. Somit ist ein Teilbereich des Gehäuses des Switches 1 transparent für das einfallendes Licht, sodass der hinter dem Bereich im Gehäuse befindliche Sensor 14 das einfallende Licht detektieren kann. Alternativ ist das Gehäuse mit einer Durchbohrung versehen, in das der Sensor 14 platziert ist, um das einfallende Licht detektieren zu können. Alternativ kann der Sensor 14 auch außen am Gehäuse des Switches 1 platziert werden.

Im Normalbetrieb ist die Mastöffnung verschlossen, sodass im Inneren des Mastes eine konstanter sehr geringer Lichteinfall detektiert wird. Eine Masttür könnte die Mastöffnung 21 des Mastes 2 auch nahezu lichtdicht verschließen. Wird nun die Mastöffnung 21 geöffnet, beispielsweise die Masttür oder Mastklappe (nicht dargestellt) entriegelt oder aufgeschlossen, also betätigt, so dringt wesentlich mehr Licht (auch nachts) in das Innere des Masts 2. Der Sensor 14 erfasst den höheren Lichteinfall und erzeugt einen Anstieg (beispielsweise sprunghaft oder stetig) der Sensorsignalamplitude über einen gewissen Zeitraum. In der Kontrolleinheit 13 wird das Sensorsignal ausgewertet und dieser Anstieg erkannt. Die Kontrolleinheit 13 bewertet dies als eine Abweichung vom Normalbetrieb und informiert (alarmiert) das Backbone 4 entsprechend. Der Alarm an die entfernte Netzkomponente 4 könnte erfolgen, wenn der Lichtsensor 14 eine vordefinierte Beleuchtungsstärke, beispielsweise größer 10 Lux oder größer 7 Lux detektiert. In der Kontrolleinheit 13 ist eine Auslöseverzögerung bzw. eine Mittelung der Sensorwerte (auch als Minihysterese bezeichnet) für eine bestimmte Zeitspanne vorgesehen. Dadurch werden Lichtschwankungen im Bereich von beispielsweise einigen 100ms nicht als Alarm zu bewerten. Somit wird kein Fehlalarm bei einem Gewitter ausgelöst.

Ein Alarmieren des Backbone 4 kann das Mitteilen einer ID des Switches 1 oder ein Standort des Mastes 2 oder beides mit einem entsprechenden Fehlercode (Lichteinfall detektiert) sein. Das Backbone 4 entscheidet über geeignete Maßnahmen. Es könnte den Vorfall als normal einstufen, wenn eine Wartung am Mast 2 in dem Backbone 4 bekannt ist. Es könnte den Vorfall als Angriff werten und die bestehende Datenverbindung zwischen Peripheriegerät 3 und Backbone 4 in einen Quarantänebereich umsiedeln und den Vorfall so weiter in einer abgesicherten Umgebung beobachten. Es könnte alternativ die Datenverbindung zum Switch 1 zu unterbinden oder den

Switch veranlassen, den Datenverbindung zwischen Backbone 4 und Peripheriegerät 3 zu unterbrechen. Es könnte das Löschen des Speicherbereichs in der Kontrolleinheit 13 anordnen.

In jedem Fall ist der Switch 1 verbessert abgesichert und insbesondere die sensiblen Daten (IP-Adressen, private Schlüssel, Signaturschlüssel, Konfigurationsdaten, Passwörter) des Switches 1 werden so besser gesichert. Ein in einer verlassenen Gegend installierter Mast 2 mit darin angeordnetem Switch 1 mit direkter Verbindung zum Backbone 4 ist somit besser gegen Angriffe gesichert.

Der in Fig. 10 verwendete Sensor 14 kann alternativ oder zusätzlich auch ein Bewegungssensor oder ein Mikroschalter sein. Diese Sensorarten detektieren eine Bewegung des Gehäuses oder das Öffnen des Gehäuses des Switches 1. Diese Maßnahmen werden von der Kontrolleinheit direkt als ein Angriff gewertet und lösen ein sofortiges Löschen der o.g. sensiblen Daten im Speicher des Switches aus. Der Switch 1 ist sodann nicht mehr konfiguriert und kann weder eine Datenverbindung zu einem Backbone 4 noch zu einem Peripheriegerät 3 herstellen oder weiterleiten. Somit führt die Entnahme des Switches 1 oder das Öffnen des Switches 1 nicht zum unbefugten Manipulieren der Datenverbindung und ein Auslesen sensibler Daten oder Abgreifen von Informationen durch den Angreifer ist so wirksam unterbunden.

Fig. 11 zeigt ein Ausführungsbeispiel eines vereinfachten Blockschaltbilds einer erfindungsgemäßen elektronischen Komponente 1. Die Vorrichtung 1 der Fig. 11 entspricht der elektronischen Komponente 1 der Fig. 10 und weist lediglich weitere Elemente auf, auf die nachfolgend Bezug genommen wird. Die in Fig. 10 bereits vorgestellten Komponenten werden hier nicht wiederholt.

Die elektronischen Komponente 1, nachfolgend Switch 1 genannt, weist andeutungsweise eine erste Platine 1a auf, die die Kontrolleinheit 13 umfasst. Zudem weist der Switch 1 eine zweite Platine 1b auf, die eine Energieversorgungseinheit 17 aufweist. Beide Platinen 1a, 1b sind über einen Verbindungsstecker 174 miteinander verbunden und werden gemeinsam in das Metallgehäuse des Switches 1 implementiert. Bevorzugt sind beide Platinen 1a, 1b Standartformfaktor-Platinen. Beide Platinen 1a, 1b weisen bevorzugt den Formfaktor PC/104 auf. Dieser Formfaktor PC/104 ermöglicht einen verkleinerten Aufbau des Switches 1 und durch diese verkleinerte Bauform ist eine Integration des Switches 1 in einen Mast 2 mit sehr geringem Durchmesser dennoch vereinfacht möglich. Beide Platinen 1a, 1b können jeweils einen vom Formfaktor PC/104 verschiedenen Formfaktor aufweisen. Der Formfaktor ermöglicht zudem ein Anordnen mehrerer Platinen übereinander, ein sogenanntes "Stacking" und Verbinden mittels

Steckverbinder 174. Damit wird die elektromagnetische Verträglichkeit der Komponenten untereinander verbessert.

Der Switch 1 weist beispielsweise einen dritten Anschluss 18 auf, an den eine Energieversorgung angelegt wird. Dieser dritte Anschluss 18 wird einem Anschluss 171 der Energieversorgungseinheit 17 zugeführt. Alternativ, hier als Strich-Punkt-Linie dargestellt, wird eine Energieversorgung über den ersten Anschluss 11, beispielsweise als PoE-Signal, zur Verfügung gestellt. In diesem Fall kann der dritte Anschluss 18 entfallen und der Aufbau vereinfacht sich.

Die Energieversorgungseinheit 17 stellt eine Energieversorgung für das Peripheriegerät 3 über einen Energieausgang 172 bereit. Diese Energieversorgung wird als PoE Signal 19 an den zweiten Anschluss 12 des Switches 1 geschaltet und so, über einen Anschluss zusammen mit dem Datensignal des zweiten Datenanschlusses 132 der Kontrolleinheit 13 an das Peripheriegerät 3 bereitgestellt. Durch die Verwendung der PoE-Signale 19 vereinfacht sich der Verkabelungsaufwand im Mast 2 erheblich und die Peripheriegeräte 3 können vom Switch 1 mit Energie versorgt werden. Auf weitere externe Energiequelle(n) zur Versorgung der Peripheriegeräte 3 kann somit verzichtet werden.

Die Energieversorgungseinheit 17 stellt zudem auch eine Energieversorgung für die Kontrolleinheit 13 über einen Energieausgang 173 bereit. Diese Energieversorgung wird beispielsweise über einen Verbindungsstecker 174 ermöglicht. Auf weitere externe Energiequelle(n) zur Versorgung der Kontrolleinheit 13 kann somit verzichtet werden.

Fig. 12 zeigt ein Ausführungsbeispiel eines vereinfachten Blockschaltbilds einer erfindungsgemäßen elektronischen Komponente 1. Die elektronische Komponente 1 der Fig. 12 entspricht der elektronischen Komponente 1 der Fig. 10 und der ersten Platine 1a der Fig. 11 und weist weitere Elemente auf, auf die nachfolgend Bezug genommen wird. Die in Fig. 10 und Fig. 11 bereits vorgestellten Komponenten werden hier nicht wiederholt.

Im Unterschied zur Fig. 10 oder Fig. 11 sind in Fig. 12 nunmehr zwei erste Anschlüsse 11a, 11b am Switch 1 vorgesehen. Am ersten Anschluss 11a ist ein erstes Backbone 4a angeschlossen. Am zweiten Anschluss 11b ist ein zweites Backbone 4b angeschlossen. Dies erhöht die Bandbreite des Switches 1 und führt folglich zu einer verbesserten Funktionalität der Peripheriegeräte 3a bis 3d. Alternativ - in Fig. 12 als Punkt-Strich-Linie dargestellt ist am zweiten Anschluss 11b ein erstes Backbone 4a angeschlossen. Dies erhöht die Bandbreite des Switches 1 und führt folglich zu einer verbesserten Funktionalität der Peripheriegeräte 3a bis 3d.

Es werden beispielsweise zwei 10Gbit SFP Module als Anschlüsse 11a, 11b verwendet. Die zwei ersten Anschlüsse 11a, 11b sind jeweils mit ersten Datenanschlüssen 131a, 131b der Kontrolleinheit 13 verbunden.

Im weiteren Unterschied zur Fig. 10 oder Fig. 11 sind in Fig. 12 nunmehr vier zweite Anschlüsse 12a, 12b, 12c, 12d am Switch 1 vorgesehen. Am zweiten Anschluss 12a ist ein erstes Peripheriegerät 3a angeschlossen bzw. anschließbar. Am zweiten Anschluss 12b ist ein zweites Peripheriegerät 3b angeschlossen bzw. anschließbar. Am zweiten Anschluss 12c ist ein drittes Peripheriegerät 3c angeschlossen bzw. anschließbar. Am zweiten Anschluss 12d ist ein viertes Peripheriegerät 3d angeschlossen bzw. anschließbar. Die vier zweiten Anschlüsse 12a, 12b, 12c, 12d sind jeweils mit zweiten Datenanschlüssen 132a, 132b, 132c, 132d der Kontrolleinheit 13 verbunden. Es können also gleichzeitig bis zu vier Peripheriegeräte 3 an einen Switch 1 angeschlossen werden. Die Zahl der anschließbaren Peripheriegeräte 3 ist erfindungsgemäß nicht einschränkend, es können bis zu 24 Peripheriegeräte 3 an einen Switch 1 angeschlossen werden. Beispielsweise wird jedes Peripheriegerät 3 mit einer 1Gbit Verbindung als Anschlüsse 12a, 12b, 12c, 12d bereitgestellt.

Im weiteren Unterschied zur Fig. 10 oder Fig. 11 sind in Fig. 12 nunmehr zumindest zwei Sensoren 14, 15 im Switch 1 vorgesehen. Der erste Sensor 14 ist dabei der in Fig. 10 bereits beschriebene Lichtsensor, dessen Sensorsignal an den Sensorsignalanschluss 133 der Kontrolleinheit 13 angeschlossen ist. Der zweite Sensor 15 ist dabei der in der Beschreibung der Fig. 10 bereits angedeutete Mikroschalter, dessen Sensorsignal (bzw. Schaltsignal) an einen zweiten Sensorsignalanschluss 134 der Kontrolleinheit 13 angeschlossen ist. Durch die Verwendung von zwei Sensoren 14, 15 und entsprechender Auswertung der Sensorsignale an den Anschlüssen 133, 134 der Kontrolleinheit 13 kann ein zweistufiges Alarmierungs- bzw. Schutzverfahren angewendet werden. So könnte bei Erkennen eines erhöhten Lichteinfalls durch den Lichtsensor 14 (=erste Stufe des Angriffs) nur die Backbones 4a, 4b entsprechend alarmiert werden und die in Fig. 10 bereits beschriebenen Maßnahmen ergriffen werden. So könnte bei Erkennen eines Öffnens des Gehäuses durch das Schaltelement 15 (=zweite Stufe des Angriffs) das Löschen/Überschreiben der sensiblen Daten aus dem Speicher des Switches 1 veranlasst werden. Damit wird die Betriebsfähigkeit des Netzwerks möglichst lange aufrechterhalten und ein Öffnen des Mastes 2 nicht automatisch zu einem Unterbrechen der Datenverbindung führen müssen. So können auch unangemeldete Wartungstätigkeiten beobachtet werden und die Funktionalität des Netzwerkes bleibt erhalten. Wird jedoch die zweite Stufe eines Angriffs detektiert, so können die sensiblen Daten zuverlässig gelöscht werden.

Im weiteren Unterschied zur Fig. 10 oder Fig. 11 ist in Fig. 12 nunmehr ein Energiespeicher 16 vorgesehen. Dieser Energiespeicher 17, beispielsweise ein Speicherkondensator mit mehreren 100 Millifarad bis mehreren Farad, stellt den Betrieb des Switches 1 auch bei kurzzeitigen Energieversorgungsschwankungen sicher und ermöglicht das Erkennen eines Angriffs auch bei entfernter Energieversorgung. So können die sensiblen Daten zuverlässig gelöscht werden, auch wenn die Energieversorgung bereits abgeschaltet ist.

Die erste Platine 1a ist über einen Steckverbinder 174 mit der zweiten Platine 1b verbunden und erhält über den Steckverbinder drei unterschiedliche Spannungen, nämlich 50V; 5V und 3,3V von der zweiten Platine 1b. Ein Energie-µC stellt aus den bereitgestellten Spannungen eine Versorgungsspannung für die Kontrolleinheit 13 und PoE Signale für die vier zweiten Anschlüssen 12a, 12b, 12c, 12d bereit. Die Anschlüsse 11a, 11b werden ebenfalls mit Energie versorgt. Die beiden Sensoren werden nicht auf der Platine 1a untergebracht, sondern an geeigneten Stellen am Gehäuse platziert und drahtgebunden - über Steckverbinder "Sensor I/O" - mit der Kontrolleinheit 13 verbunden. Die Kontrolleinheit 13 wird mit zwei ersten Anschlüssen 11a, 11b und vier zweiten Anschlüssen 12a, 12b, 12c, 12d verbunden.

Zusätzlich sind 4 Status LED vorgesehen, die den Zustand des Switches 1 nach außen (außerhalb des Gehäuses des Switches 1) visualisieren, wobei eine der Status-LED anzeigt, ob eine Energieversorgung anliegt, eine der Status-LED anzeigt, ob der Switch eingeschaltet ist, eine dritte Status-LED zweifarbig ist und anzeigt, ob eine Datenverbindung mit dem Backbone 4a vorhanden ist, und eine vierte Status-LED zweifarbig ist und anzeigen, ob eine Datenverbindung mit dem Backbone 4a bzw. 4b (je nachdem wie beschaltet wurde) vorhanden ist. Zusätzlich sind 4 LED vorgesehen, die den Verbindungszustand mit dem jeweiligen Peripheriegerät 3a, 3b, 3c, 3d anzeigen. Diese LED werden über Durchbohrungen am Gehäuse oder transparente Teilbereiche im Gehäuse von außen sichtbar angeordnet.

Die Platine 1a verfügt über einen Service-Anschluss, über den mittels eines Treiber-Bausteins die Kontrolleinheit 13 aktualisiert und gewartet werden kann.

Die zweite Platine 1b weist beispielsweise den dritten Anschluss 18 auf, an den eine Energieversorgung, beispielsweise 110VAC bis 230VAC mit 50Hz oder 60Hz angelegt wird. Dieser dritte Anschluss 18 wird einem Anschluss 171 der Energieversorgungseinheit 17 zugeführt.

Die Energieversorgungseinheit 17 stellt eine Energieversorgung für das Peripheriegerät 3 über einen Energieausgang 172 bereit. Dazu ist ein Netzteil mit Weitbereichseingang mit einer

Ausgangsspannung von 50V und 3A implementiert. Die Abwärme des Netzteils wird durch direkte Montage des Netzteilmoduls auf das Metallgehäuse abgeführt. Das Gehäuse des Switches 1 ist somit gleichzeitig Kühlkörper für das Netzteil. Die Kühlleistung des Gehäuses 6 des Switches weist mindestens 1K/W auf. Somit kann auf zusätzliche Lüfter oder Heat-Pipes verzichtet werden. Diese Energieversorgung wird als PoE Signal 19 über den Steckverbinder 174 an den zweiten Anschluss 12 des Switches 1 geschaltet und so, über einen Anschluss zusammen mit dem Datensignal des zweiten Datenanschlusses 132 der Kontrolleinheit 13 an das Peripheriegerät 3 bereitgestellt.

Die Energieversorgungseinheit 17 stellt zudem auch eine Energieversorgung für die Kontrolleinheit 13 über einen Energieausgang 173 bereit. Dazu ist ein DC-DC Schaltregler mit einer Ausgangsspannung von 5V und 6A implementiert, der aus dem o.g. Netzteil gespeist wird. Die Energieversorgungen werden beispielsweise über den Verbindungsstecker 174 an die erste Platine 1a weitergeleitet. Auf weitere externe Energiequelle(n) zur Versorgung der Kontrolleinheit 13 oder der Peripheriegeräte 3 kann somit verzichtet werden.

Fig. 13 zeigt ein maßstabsgetreues Ausführungsbespiel eines beispielhaften Mastes 2, in den ein Switch 1 angeordnet wird. Der Mast verfügt über drei übereinander angeordnete Mastöffnungen 21, die jeweils mittels dreikantigem Türverschluss abschließbar sind. Jede Mastöffnung 21 ist mit einer Masttür der Größe 100 x 400 Millimeter verschließbar. Das Gehäuse des Switches 1 muss durch diese Masttür-Größe in das Innere des Mastes 2 eingebracht werden können, sodass die Außenmaße des Gehäuses auf diese Mastöffnungsgrößen beschränkt sind. Der Durchmesser des Mastes 2 am Fuße des Mastes beträgt 246 Millimeter. Im Inneren des Mastes verläuft ein Gerätesteg, beispielsweise als Hutschiene oder als eine Schiene ausgebildet. An diesen Gerätesteg wird das Gehäuse 6 des Switches angeordnet.

Fig. 14zeigt drei maßstabsgetreue Ausführungsbespiele für beispielhafte Mastöffnungen 21 in Masten 2, durch die hindurch ein erfindungsgemäße Switch 1 in einen Mast 2 angeordnet wird. Es ist vorgesehen, nur ein Gehäuse 6 für den Switch 1 vorzusehen, sodass die Abmessungen der kleinsten Mastöffnung 21, hier die des Masttyps LM3-SC, die Außenmaße des Gehäuses 6 des Switches 1 beschränken. Beim Masttyp LM3-SC beträgt der Durchmesser in Höhe der Mastöffnung 21 zwischen 130,85 und 136,07 Millimeter, die Mastöffnung 21 hat eine Abmessung von 85x300 Millimeter.

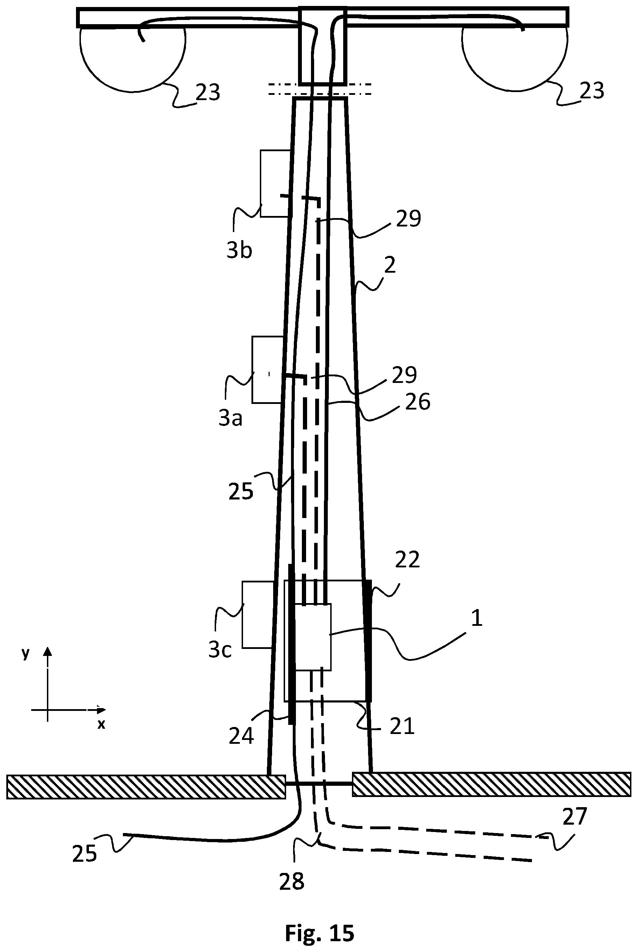

Fig. 15 zeigt ein Ausführungsbespiel eines erfindungsgemäßen Systems bestehend aus einem Mast 2 mit darin angeordnetem Switch 1. Der Mast 2 ist dabei bevorzugt ein Mast, wie er in den Fig. 13 oder 14 dargestellt wurde. Der Switch 1 entspricht einem der Switche der Fig. 10 bis 13.

Der Switch 1 ist durch die Mastöffnung 21 in das Innere des Mastes 2 eingebracht und dort an einer Hutschiene 24 mechanisch befestigt, beispielsweise durch eine Krallen-, eine Klemm-, und/oder eine Schraubverbindung. Alternativ kann in einer gut gesicherten Umgebung auch eine Magnetverbindung zum Befestigen des Switches 1 im Inneren des Mastes 2 verwendet werden. Der Mast 2 hat als Funktionseinheit zwei Beleuchtungsmittel 23. Diese Beleuchtungsmittel 23, beispielsweise LED-Beleuchtungen, sind entweder mit einer eigenen Energieversorgung 25 oder mit einer PoE Versorgung 26 des Switches 1 verbunden und werden entsprechend darüber mit Energie versorgt.

An den Mast 2 ist ein Peripheriegerät 3b, beispielsweise ein Verkehrssensor, angebracht und mittels Datenverbindung 29 über den Switch 1 mit einem Backbone verbunden, siehe angedeutete Datenverbindung 27 zum Backbone.

An den Mast 2 ist ein Peripheriegerät 3a, beispielsweise eine Kamera oder ein WLAN-AP, angebracht und mittels Datenverbindung 29 über den Switch 1 mit einem Backbone verbunden, siehe angedeutete Datenverbindung 27 zum Backbone.

An den Mast 2 ist ein Peripheriegerät 3c, beispielsweise eine Elektrofahrzeug-Ladestation, angebracht und mittels Datenverbindung 29 über den Switch 1 mit einem Backbone verbunden, siehe angedeutete Datenverbindung 27 zum Backbone.

Im Rahmen der Erfindung können alle beschriebenen und/oder gezeichneten und/oder beanspruchten Elemente beliebig miteinander kombiniert werden.

### BEZUGSZEICHENLISTE

1 Elektronische Komponente, Netzwerkkomponente, Switch,
1a Erste Platine
1b Zweite Platine
   11, 11a, 11b Erster Datenanschluss
   12, 12a, 12b, 12c, 12d Zweiter Datenanschluss
   13 Kontrolleinheit
      131, 131a, 131b Erster Datenanschluss
      132, 132a, 132b, 132c, 132d Zweiter Datenanschluss
      133 Sensorsignalanschluss
      134 Zweiter Sensorsignalanschluss
   14 Sensor
   15 zweiter Sensor
   16 Energiespeicher
   17 Energieversorgungseinheit
      171 Erster Energieanschluss
      172 Zweiter Energieanschluss
      172 Dritter Energieanschluss
      174 Verbindungsanschluss
   18 Erster Energieanschluss
   19 Energiesignal, PoE
2 Außenbereichsvorrichtung, Mast
   21 Öffnung
   22 Tür, Klappe
      221 Verschlusselement
   23 Leuchtmittel, Signal, Ampel
   24 Befestigungselement, Schiene
   25 Energieversorgung Leuchtmittel/Ladestation
   26 Power over Ethernet
   27 Datenverbindung zum Backbone
   28 Energieversorgung
   29 Datenverbindung Peripheriegerät (Funktionseinheit)
3, 3a, 3b, 3c, 3d Funktionseinheit
4, 4a, 4b Entfernte Netzwerkkomponente
5 Server
6 Gehäuse
   60 Haltebereich
   61 Deckel
      611 Durchbohrung für zweiten Datenanschluss
   62 Boden
      621 Durchbohrung für ersten Datenanschluss
      622 Durchbohrung für Energieanschluss
   63 Erstes Seitenteil
      631 Ausnehmung für Energieanschluss
   64 Zweites Seitenteil
      641 Erhebung
      642 Befestigungshülse für Platine
      643 LED - Bereiche
   65 Durchbohrung, Teilbereich für Sensor
   66 Schraubelement
   67 Kühlrippen
   68 Dichtung
   69a,b Verbindungslippe
7 Haltevorrichtung
   71 Klemmverbindung
   72 Halteschiene
   73 erstes Halteelement
   74 zweites Halteelement

## Patentansprüche

1. Eine Außenbereichsvorrichtung (2) mit einer in einem Hohlraum der Außenbereichsvorrichtung (2) betriebsbereit angeordneten elektronischen Komponente (1),
- wobei die elektronische Komponente (1) mit einer elektrischen Funktionseinheit (3) der Außenbereichsvorrichtung (3) elektrisch verbunden ist,
- wobei die elektronische Komponente (1) ein Komponentengehäuse (6) aufweist,
- wobei das Komponentengehäuse (6) ein Kühlkörper für die elektronische Komponente (1) ist,
- wobei die elektronische Komponente (1) durch das Komponentengehäuse (6) in einem Hohlraum der Außenbereichsvorrichtung (2) mechanisch fixiert ist,
- wobei das Komponentengehäuse (6) vollständig beabstandet von Innenseiten der Außenbereichsvorrichtung (2) fixiert ist, sodass eine Luftumströmung des gesamten Komponentengehäuses (6) den Abtransport von durch die elektronische Komponente (1) erzeugte Wärme ermöglicht; und
- wobei die Außenbereichsvorrichtung (2) eine Öffnung (21) zum Einbringen der elektronischen Komponente (1) in den Hohlraum aufweist.

2. Die Außenbereichsvorrichtung (2) nach Anspruch 1, wobei die Außenbereichsvorrichtung (2) ein pfeilerartiger Hohlkörper, insbesondere ein Mast, ist.

3. Die Außenbereichsvorrichtung (2) nach Anspruch 1 oder 2, wobei die Außenbereichsvorrichtung (2) ein Befestigungselement (24) im Hohlraum aufweist, wobei das Befestigungselement (24) parallel zu einer Längsachse (Y) der Außenbereichsvorrichtung (2) in der Außenbereichsvorrichtung (2) angeordnet ist, um das Komponentengehäuse (6) im Hohlraum der Außenbereichsvorrichtung (2) mechanisch zu fixieren und/oder das Befestigungselement (24) an einer Innenlängsseite der Außenbereichsvorrichtung (2) mechanisch fixiert ist, um das Komponentengehäuse (6) im Hohlraum der Außenbereichsvorrichtung (2) mechanisch zu fixieren.

4. Die Außenbereichsvorrichtung (2) nach Anspruch 3, wobei das Komponentengehäuse (6) zumindest einen Haltebereich (60) an einer Außenseite (61, 62) des Komponentengehäuses (6) aufweist, wobei an den Haltebereich (60) eine Haltevorrichtung (7) formschlüssig angreift, wobei die Haltevorrichtung (7) mit dem Befestigungselement (24) der Außenbereichsvorrichtung (2) mechanisch oder magnetisch verbunden ist.

5. Die Außenbereichsvorrichtung (2) nach Anspruch 4, wobei die Haltevorrichtung (7) mit dem Befestigungselement (24) der Außenbereichsvorrichtung (2) durch eine Klemmverbindung (71), durch eine Rastverbindung und/oder durch eine Schraubverbindung mechanisch verbunden ist.

6. Die Außenbereichsvorrichtung (2) nach einem der vorhergehenden Ansprüche, wobei das Komponentengehäuse (6) der Kühlkörper für eine Kontrolleinheit (13) und/oder eine Energieversorgungseinheit (17) innerhalb des Komponentengehäuses (9) der elektronischen Komponente (1) ist.

7. Die Außenbereichsvorrichtung (2) nach Anspruch 6, wobei das Komponentengehäuse (6) zumindest eine Erhebung (641) an einer Innenseite des Komponentengehäuses (6) aufweist, wobei sich die Erhebung (641) in das Innere des Komponentengehäuses (6) erstreckt und der Kontrolleinheit (13) und/oder der Energieversorgungseinheit (17) der elektronischen Komponente (1) direkt gegenübersteht, bevorzugt die Kontrolleinheit (13) und/oder die Energieversorgungseinheit (17) der elektronischen Komponente (1) direkt kontaktiert.

8. Die Außenbereichsvorrichtung (2) nach einem der vorhergehenden Ansprüche, wobei die elektronische Komponente (1) elektrische und/oder optische Anschlüsse (11, 12, 18) ausschließlich an einer Oberseite und/oder einer, der Oberseite gegenüberliegenden, Unterseite des Komponentengehäuses (6) aufweist, wobei die Oberseite und die Unterseite der elektronischen Komponente (1) im Wesentlichen senkrecht zu einer Längsachse (y) der Außenbereichsvorrichtung (2) ausgerichtet sind.

9. Die Außenbereichsvorrichtung (2) nach Anspruch 8, wobei das Komponentengehäuse (6) mehrteilig (61, 62, 63, 64) ausgebildet ist und die elektrischen und/oder optischen Anschlüsse (11, 12, 18) am Komponentengehäuse (6) in einem Oberteil (61) des Komponentengehäuses (6) und/oder Unterteil (62) des Komponentengehäuses (6) angeordnet sind.

10. Die Außenbereichsvorrichtung (2) nach einem der vorhergehenden Ansprüche, wobei das Komponentengehäuse (2) mehrteilig ist, wobei ein erstes Seitenteil (63) des Komponentengehäuses (6) lösbar formschlüssig mit einem zweiten Seitenteil (64) des Komponentengehäuse (6)verbunden ist.

11. Die Außenbereichsvorrichtung (2) nach einem der vorhergehenden Ansprüche, wobei das Komponentengehäuse (6) zumindest eine Leiterplatine (1a) in einem Formfaktor, insbesondere einem PC/104 Formfaktor, aufweist.

12. Die Außenbereichsvorrichtung (2) nach einem der vorhergehenden Ansprüche, wobei die elektronische Komponente (1) eine Energieversorgungseinheit (17) umfasst, wobei die Energieversorgungseinheit (17) aufweist:
- einen ersten Energieanschluss (171) zum Zuführen einer komponentenexternen Versorgungsenergie;
- zumindest einen zweiten Energieanschluss (172) zum Abgreifen einer Versorgungsenergie für die elektrische Funktionseinheit (3) der Außenbereichsvorrichtung (2).

13. Die Außenbereichsvorrichtung (2) nach Anspruch 12, wobei der zweite Energieanschluss (172) ein Power-on-Ethernet, PoE, Energiesignal bereitstellt, das mit einem zu übertragenden Datensignal zwischen der elektronischen Komponente (1) und der elektrischen Funktionseinheit (3) der Außenbereichsvorrichtung (2) zusammengeführt wird.

14. Die Außenbereichsvorrichtung (2) nach einem der vorhergehenden Ansprüche, wobei die elektronische Komponente (1) eine Kontrolleinheit (13) umfasst, wobei die Kontrolleinheit (13) aufweist:
- zumindest einen ersten Datenanschluss (131) eingerichtet zum Übertragen eines Datensignals zwischen der elektronischen Komponente (1) und einer von der Außenbereichsvorrichtung (2) entfernten Netzwerkkomponente (4);
- zumindest einen zweiten Datenanschluss (132) eingerichtet zum Übertragen eines Datensignals zwischen der elektronischen Komponente (1) und der Funktionseinheit (3) der Außenbereichsvorrichtung (2);
- wobei die Kontrolleinheit (13) eingerichtet ist zum Weiterleiten einer Datenkommunikation zwischen der entfernten Netzwerkkomponente (4) und der Funktionseinheit (3) der Außenbereichsvorrichtung (2).

15. Die Außenbereichsvorrichtung (2) nach einem der vorhergehenden Ansprüche,
- wobei die elektronische Komponente (1) einen Sensor (14, 15) an dem Komponentengehäuse (6) eingerichtet zum Bereitstellen eines Sensorsignals aufweist; und
- wobei eine Kontrolleinheit (13) der elektronischen Komponente (1) eingerichtet ist zum:
- Auswerten des empfangenen Sensorsignals;
- Erkennen einer Änderung des Sensorsignals; und
- Alarmieren einer von der Außenbereichsvorrichtung (2) entfernten Netzwerkkomponente (4), wenn die Änderung des Sensorsignals durch die Kontrolleinheit (13) erkannt wird.

## Claims

1. An outdoor device (2) with an electronic component (1) arranged operably in a cavity of said outdoor device (2),
- wherein said electronic component (1) is electrically connected to an electrical functional unit (3) of said outdoor device (3),
- wherein said electronic component (1) has a component housing (6),
- wherein said component housing (6) is a heat sink for said electronic component (1),
- wherein said electronic component (1) is mechanically fixed by said component housing (6) in a cavity of said outdoor device (2); and
- wherein said component housing (6) is fixed completely spaced apart from inner sides of said outdoor device (2), so that air flowing around the entire component housing (6) enables the dissipation of heat generated by said electronic component (1); and
- wherein said outdoor device (2) has an opening (21) for inserting said electronic component (1) into the cavity.

2. The outdoor device (2) according to claim 1, wherein said outdoor device (2) is a pillar-like hollow body, in particular a pole.

3. The outdoor device (2) according to claim 1 or 2, wherein said outdoor device (2) has a fastening element (24) in the cavity, wherein said fastening element (24) is arranged in parallel to a longitudinal axis (Y) of said outdoor device (2) in said outdoor device (2) to mechanically fix said component housing (6) in the cavity of the outdoor device (2) and/or wherein the fastening element (24) is mechanically fixed on an inner longitudinal side of said outdoor device (2) to mechanically fix said component housing (6) in the cavity of said outdoor device (2).

4. The outdoor device (2) according to claim 3, wherein said component housing (6) has at least one holding region (60) on an outer side (61, 62) of said component housing (6), wherein a holding device (7) engages with said holding region (60) in a form-fitting manner, wherein said holding device (7) is mechanically or magnetically connected to said fastening element (24) of said outdoor device (2).

5. The outdoor device (2) according to claim 4, wherein said holding device (7) is mechanically connected to said fastening element (24) of said outdoor device (2) by a clamping connection (71), by a latching connection and/or by a screw connection.

6. The outdoor device (2) according to any one of the preceding claims, wherein said component housing (6) is the heat sink for a control unit (13) and/or an energy supply unit (17) within said component housing (9) of said electronic component (1).

7. The outdoor device (2) according to claim 6, wherein said component housing (6) has at least one protrusion (641) on an inner side of said component housing (6), wherein said protrusion (641) extends into the interior of said component housing (6) and is directly opposite said control unit (13) and/or said energy supply unit (17) of said electronic component (1) and preferably contacts said control unit (13) and/or said energy supply unit (17) of said electronic component (1) directly.

8. The outdoor device (2) according to any one of the preceding claims, wherein said electronic component (1) has electrical and/or optical ports (11, 12, 18) exclusively on one top side and/or a bottom side being opposite said top side, of said component housing (6), wherein said top side and said bottom side of said electronic component (1) are oriented substantially perpendicular to a longitudinal axis (y) of said outdoor device (2)..

9. The outdoor device (2) according to claim 8, wherein said component housing (6) is formed in a plurality of parts (61, 62, 63, 64) and the electrical and/or optical ports (11, 12, 18) are arranged on said component housing (6) in an upper part (61) of said component housing (6) and/or a lower part (62) of said component housing (6).

10. The outdoor device (2) according to any one of the preceding claims, wherein said component housing (2) has a plurality of parts, wherein a first lateral part (63) of said component housing (6) is detachably connected to a second lateral part (64) of said component housing (6) in a form-fitting manner.

11. The outdoor device (2) according to any one of the preceding claims, wherein said component housing includes at least one printed circuit board (1a) in a form factor, in particular a form factor of PC/104.

12. The outdoor device (2) according to any one of the preceding claims, wherein said electronic component (1) comprises an energy supply unit (17), wherein said energy supply unit (17) includes:
- a first energy port (171) for supplying a supply energy external to said component;
- at least one second energy port (172) for diverting a supply energy for said electrical functional unit (3) of said outdoor device (2).

13. The outdoor device (2) according to claim 12, wherein said second energy port (172) provides a Power-on-Ethernet (PoE) energy signal combined with a data signal to be transmitted between said electronic component (1) and said electrical functional unit (3) of said outdoor device (2).

14. The outdoor device (2) according to any one of the preceding claims, wherein said electronic component (1) comprises a control unit (13), wherein said control unit (13) comprises:
- at least one first data port (131) configured to transmit a data signal between said electronic component (1) and a network component (4) remote from said outdoor device (2); and
- at least one second data port (132) configured to transmit a data signal between said electronic component (1) and said functional unit (3) of said outdoor device (2),
- wherein said control unit (13) is configured to forward data communication between said remote network component (4) and said functional unit (3) of said outdoor device (2).

15. The outdoor device (2) according to any one of the preceding claims,
- wherein said electronic component (1) includes a sensor (14, 15) on said component housing (6) configured to provide a sensor signal; and
- wherein a control unit (13) of said electronic component (1) is configured to:
- evaluate the received sensor signal;
- detect a change in the sensor signal; and
- alert a network component (4) remote from said outdoor device (2) when the change in the sensor signal is detected by said control unit (13).

## Revendications

1. Dispositif de plein air (2) ayant un composant électronique (1) agencé de manière opérationnelle dans une cavité du dispositif de plein air (2) ;
- dans lequel le composant électronique (1) est électriquement relié à une unité fonctionnelle électrique (3) du dispositif de plein air (3),
- dans lequel le composant électronique (1) comporte un boîtier de composant (6),
- dans lequel le boîtier de composant (6) est un dissipateur thermique pour le composant électronique (1),
- dans lequel le composant électronique (1) est fixé mécaniquement par le boîtier de composant (6) dans une cavité du dispositif de plein air (2),
- dans lequel le boîtier de composant (6) est fixé entièrement espacé de côtés intérieurs du dispositif de plein air (2), de telle sorte qu'un écoulement d'air autour de tout l'ensemble du boîtier de composant (6) permet la dissipation de la chaleur générée par le composant électronique (1) ; et
- dans lequel le dispositif de plein air (2) comporte une ouverture (21) destinée à insérer le composant électronique (1) dans la cavité.

2. Dispositif de plein air (2) selon la revendication 1, dans lequel le dispositif de plein air (2) est un corps creux en forme de pilier, en particulier un mât.

3. Dispositif de plein air (2) selon la revendication 1 ou 2, dans lequel le dispositif de plein air (2) comporte un élément de fixation (24) dans la cavité, dans lequel l'élément de fixation (24) est agencé parallèlement à un axe longitudinal (Y) du dispositif de plein air (2) dans le dispositif de plein air (2) afin de fixer mécaniquement le boîtier de composant (6) dans la cavité du dispositif de plein air (2) et/ou l'élément de fixation (24) est fixé mécaniquement sur un côté longitudinal intérieur du dispositif de plein air (2) afin de fixer mécaniquement le boîtier de composant (6) dans la cavité du dispositif de plein air (2).

4. Dispositif de plein air (2) selon la revendication 3, dans lequel le boîtier de composant (6) comporte au moins une zone de retenue (60) sur un côté extérieur (61, 62) du boîtier de composant (6), dans lequel un dispositif de retenue (7) s'applique par complémentarité de formes sur la zone de retenue (60), dans lequel le dispositif de retenue (7) est assemblé mécaniquement ou magnétiquement à l'élément de fixation (24) du dispositif de plein air (2).

5. Dispositif de plein air (2) selon la revendication 4, dans lequel le dispositif de retenue (7) est assemblé mécaniquement avec l'élément de fixation (24) du dispositif de plein air (2) par un assemblage par serrage (71), par un assemblage par enclenchement et/ou par un assemblage vissé.

6. Dispositif de plein air (2) selon l'une des revendications précédentes, dans lequel le boîtier de composant (6) est le dissipateur thermique pour une unité de contrôle (13) et/ou une unité d'alimentation en énergie (17) à l'intérieur du boîtier de composant (9) du composant électronique (1).

7. Dispositif de plein air (2) selon la revendication 6, dans lequel le boîtier de composant (6) comporte au moins une saillie (641) sur un côté intérieur du boîtier de composant (6), dans lequel la saillie (641) s'étend à l'intérieur du boîtier de composant (6) et l'unité de contrôle (13) et/ou l'unité d'alimentation en énergie (17) du composant électronique (1) est directement à l'opposé, l'unité de contrôle (13) et/ou l'unité d'alimentation en énergie (17) du composant électronique (1) étant de préférence directement en contact.

8. Dispositif de plein air (2) selon l'une des revendications précédentes, dans lequel le composant électronique (1) comporte des connexions électriques et/ou optiques (11, 12, 18) exclusivement sur un côté supérieur et/ou un côté inférieur du boîtier de composant (6) opposé au côté supérieur, dans lequel le côté supérieur et le côté inférieur du composant électronique (1) sont orientés de manière sensiblement perpendiculaire à un axe longitudinal (y) du dispositif de plein air (2).

9. Dispositif de plein air (2) selon la revendication 8, dans lequel le boîtier de composant (6) est formé en plusieurs parties (61, 62, 63, 64) et les connexions électriques et/ou optiques (11, 12, 18) sur le boîtier de composant (6) sont agencées dans une partie supérieure (61) du boîtier de composant (6) et/ou une partie inférieure (62) du boîtier de composant (6).

10. Dispositif de plein air (2) selon l'une des revendications précédentes, dans lequel le boîtier de composant (2) est en plusieurs parties, dans lequel une première partie latérale (63) du boîtier de composant (6) est assemblée par complémentarité de formes, de manière détachable, avec une seconde partie latérale (64) du boîtier de composant (6).

11. Dispositif de plein air (2) selon l'une des revendications précédentes, dans lequel le boîtier de composant (6) comporte au moins une carte à circuit imprimé (1a) avec un facteur de forme, en particulier un facteur de forme PC/104.

12. Dispositif de plein air (2) selon l'une des revendications précédentes, dans lequel le composant électronique (1) comprend une unité d'alimentation en énergie (17), dans lequel l'unité d'alimentation en énergie (17) comporte :
- une première connexion d'énergie (171) pour fournir une énergie d'alimentation externe à un composant ;
- au moins une seconde connexion d'énergie (172) pour dévier une énergie d'alimentation pour l'unité fonctionnelle électrique (3) du dispositif de plein air (2).

13. Dispositif de plein air (2) selon la revendication 12, dans lequel la seconde connexion d'énergie (172) fournit un signal d'énergie d'alimentation sur Ethernet, PoE, qui est combiné avec un signal de données à transmettre entre le composant électronique (1) et l'unité fonctionnelle électrique (3) du dispositif de plein air (2).

14. Dispositif de plein air (2) selon l'une des revendications précédentes, dans lequel le composant électronique (1) comprend une unité de contrôle (13), dans lequel l'unité de contrôle (13) comporte :
- au moins une première connexion de données (131) configurée pour transmettre un signal de données entre le composant électronique (1) et un composant de réseau (4) distant du dispositif de plein air (2) ;
- au moins une seconde connexion de données (132) configurée pour transmettre un signal de données entre le composant électronique (1) et l'unité fonctionnelle (3) du dispositif de plein air (2) ;
- dans lequel l'unité de contrôle (13) est configurée pour transmettre une communication de données entre le composant de réseau distant (4) et l'unité fonctionnelle (3) du dispositif de plein air (2).

15. Dispositif de plein air (2) selon l'une des revendications précédentes,
- dans lequel le composant électronique (1) comporte un capteur (14, 15) sur le boîtier de composant (6) configuré pour fournir un signal de capteur ; et
- dans lequel une unité de contrôle (13) du composant électronique (1) est configurée pour :
- évaluer le signal de capteur reçu ;
- détecter une variation du signal de capteur ; et
- alerter un composant de réseau (4) distant du dispositif de plein air (2) lorsque la variation du signal de capteur est détectée par l'unité de contrôle (13).
